# EUROPEAN PATENT SPECIFICATION

(11) **EP 4 459 671 B1**
(45) Date of publication and mention of the grant of the patent: **23.07.2025**
(21) Application number: 24152376.0
(22) Date of filing: 17.01.2024
(51) Int. Cl.: H01L 21/768, H01L 23/48, H01L 23/485, H01L 23/528

(54) **SEMICONDUCTOR DEVICE**
HALBLEITERANORDNUNG
DISPOSITIF SEMI-CONDUCTEUR

(30) Priority: 04.05.2023 KR 20230058181
(43) Date of publication of application: 06.11.2024
(73) Proprietor: Samsung Electronics Co., Ltd., Suwon-si, Gyeonggi-do 16677 (KR)
(72) Inventor: PARK, Myung Joo, 16677 Suwon-si, Gyeonggi-do (KR); HWANG, Jae Won, 16677 Suwon-si, Gyeonggi-do (KR); LEE, Ho Jin, 16677 Suwon-si, Gyeonggi-do (KR)
(74) Representative: Kuhnen & Wacker Patent- und Rechtsanwaltsbüro PartG mbB

(56) References cited:
- US-A1- 2020 373 331
- US-A1- 2022 037 236
- US-A1- 2022 416 017

## Description

### BACKGROUND

A scaling technology for increasing a density of a semiconductor device, a multi-gate transistor in which a multi-channel active pattern (or a silicon body) having a fin or nanowire shape is formed on a substrate and gates are formed on a surface of the multi-channel active pattern.

Such a multi-gate transistor uses a three-dimensional channel, which facilitates scaling. In addition, a current control capability may be improved without increasing a gate length of the multi-gate transistor. Furthermore, a short channel effect (SCE), where a channel region potential is adversely affected by a drain voltage, may be suppressed.

Meanwhile, as a pitch size of the semiconductor device decreases, research has focused on decreasing a capacitance and securing electrical stability between contacts in the semiconductor device.

US 2022/037236 A1 discloses a semiconductor device that includes a semiconductor substrate having a first surface and a second surface, which are opposite to each other, an active pattern protruding from the first surface of the semiconductor substrate, the active pattern including a source/drain region, a power rail electrically connected to the source/drain region, a power delivery network disposed on the second surface of the semiconductor substrate, and a penetration via structure penetrating the semiconductor substrate and electrically connected to the power rail and the power delivery network. The penetration via structure includes a first conductive pattern electrically connected to the power rail and a second conductive pattern electrically connected to the power delivery network. The first conductive pattern includes a material different from the second conductive pattern.

### SUMMARY

Aspects of the present invention provide a semiconductor device with improved reliability.

A semiconductor device according to the invention is defined by independent claim 1. Further developments of the semiconductor device according to the invention are specified by the dependent claims.

The above and other aspects of the present disclosure will become more apparent to one of ordinary skill in the art to which the present disclosure pertains by referencing the detailed description of the present disclosure given below.

### BRIEF DESCRIPTION OF THE DRAWINGS

FIG. 1 is an example of a layout diagram for describing a semiconductor device.
FIG. 2 is a cross-sectional view taken along line A-A of FIG. 1.
FIG. 3 is a cross-sectional view taken along line B-B of FIG. 1.
FIG. 4 is a cross-sectional view taken along line C-C of FIG. 1.
FIGS. 5 to 12 are views for examples of semiconductor devices.
FIG. 13 is an example of a layout diagram for describing a semiconductor device.
FIG. 14 is a cross-sectional view taken along line D-D of FIG. 13.
FIGS. 15 to 17 are cross-sectional views taken along line E-E of FIG. 13.
FIGS. 18 to 27 are views for describing intermediate steps of a method of manufacturing a semiconductor device.

### DETAILED DESCRIPTION

The terms "first", "second", and the like as used herein are used to describe various elements or components, but these elements or components are not limited by these terms. These terms are used only in order to distinguish one element or component from another element or component. Accordingly, a first element or component mentioned below may also be a second element or component within the technical spirit of the present disclosure.

In the drawings of a semiconductor device, a fin field effect transistor (FinFET) including a channel region having a fin-shaped pattern shape, a transistor including a nanowire or a nanosheet, and a multi-bridge channel field effect transistor (MBCFET^{™}) or a vertical field effect transistor (vertical FET) have been illustrated by way of example, but the present disclosure is not limited thereto. The semiconductor device may include a tunneling field effect transistor (tunneling FET) or a three-dimensional (3D) transistor. The semiconductor device may include a planar transistor. In addition, the technical concept of the present disclosure may be applied to two-dimensional (2D) material-based FETs and heterostructures thereof.

In addition, the semiconductor device may include a bipolar junction transistor, a laterally diffused metal oxide semiconductor (LDMOS) transistor, or the like.

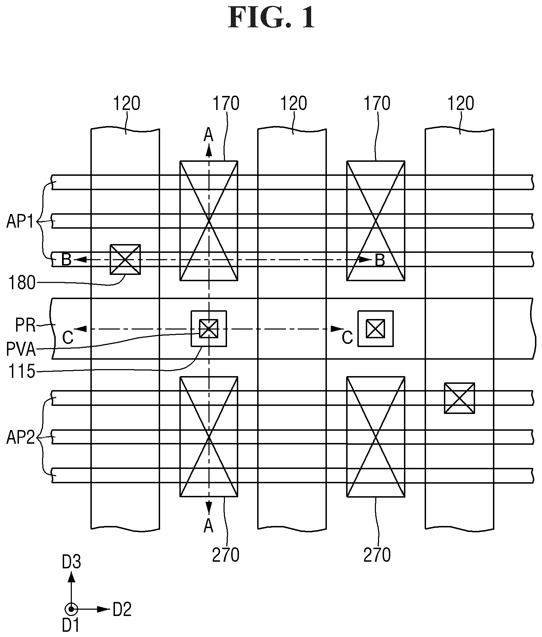

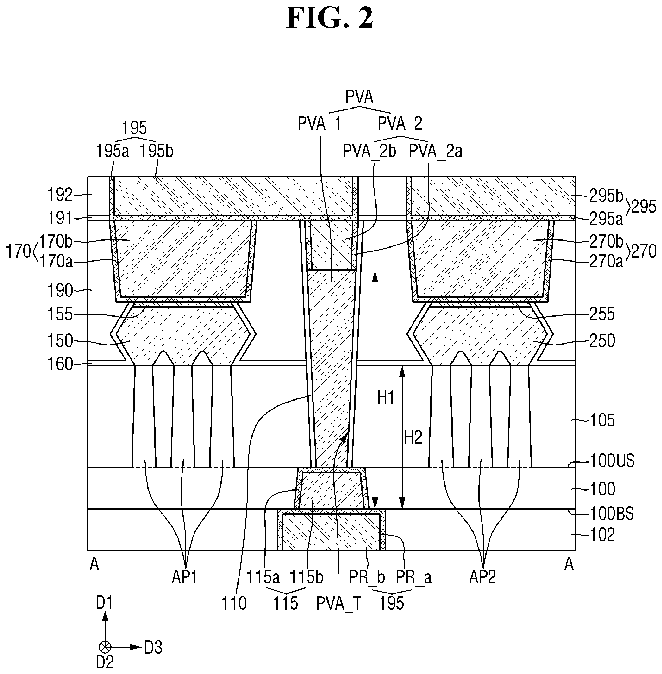

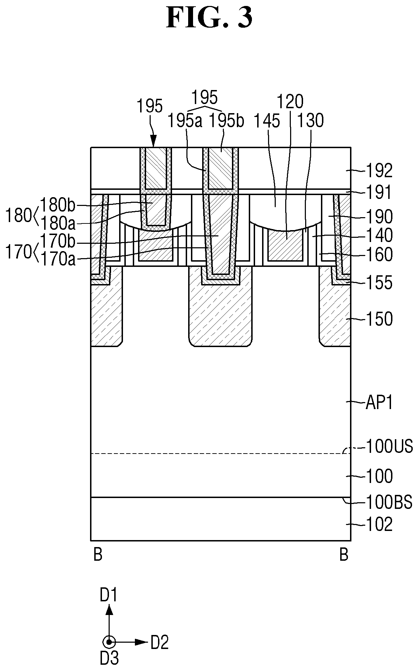

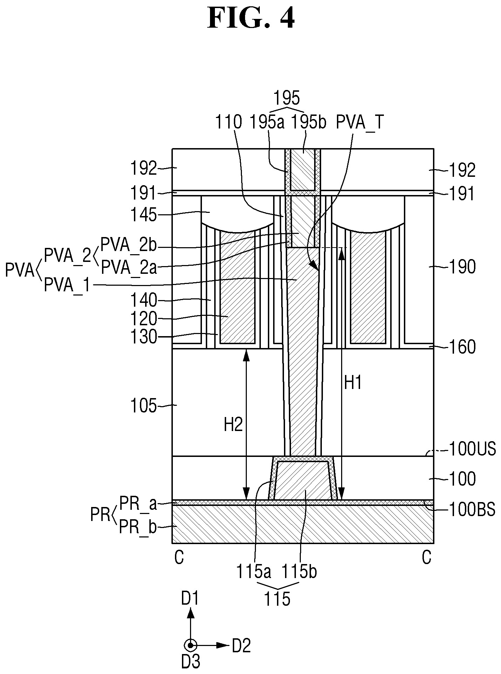

FIG. 1 is an example of a layout diagram for describing a semiconductor device 101. FIG. 2 is a cross-sectional view taken along line A-A of FIG. 1. FIG. 3 is a cross-sectional view taken along line B-B of FIG. 1. FIG. 4 is a cross-sectional view taken along line C-C of FIG. 1. For convenience of explanation, via plugs 195 and 295 have not been illustrated in FIG. 1.

Referring to FIGS. 1 to 4, a semiconductor device 101 may include one or more first active patterns AP1, one or more second active patterns AP2, a plurality of gate electrodes 120, first source/drain contacts 170, second source/drain contacts 270, gate contacts 180, a power rail PR, a power rail via PVA, and a buried conductive pattern 115. In the implementations illustrated herein, the phrase source/drain contacts may be understood to mean a contact connected to a source terminal region or a drain terminal region of a transistor. The phrase source/drain barrier film can refer to a barrier film for a source terminal region or a drain terminal region of a transistor. In some implementations, whether a region is a source or drain terminal region can depend on the applied voltage.

First, a substrate 100 may be provided. The substrate 100 may include a plurality of active regions and a field region. Each of the plurality of active regions may be an area where the first active pattern AP1 or the second active pattern AP2 is disposed. The field region may be formed immediately adjacent to the plurality of active regions. The field region may border the plurality of active regions.

The plurality of active regions are spaced apart from each other. The plurality of active regions may be separated from each other by the field region. In other words, an element isolation film may be disposed around the plurality of active regions spaced apart from each other. In this case, a portion of the element isolation film positioned between the plurality of active regions may be the field region. For example, a portion where a channel region of a transistor, which may be an example of the semiconductor device, is formed may be the active region, and a portion dividing the channel region of the transistor formed in the active region may be the field region. Alternatively, the active region may be a region where a fin-shaped pattern or a nanosheet used as a channel region of a transistor is formed, and the field region may be a region where the fin-shaped pattern or the nanosheet used as the channel region is not formed.

The substrate 100 may include a first surface 100US and a second surface 100BS opposite to each other in a first direction D1. The substrate 100 may be a silicon substrate or a silicon-on-insulator (SOI). Alternatively, the substrate 100 may include silicon germanium, silicon germanium on insulator (SGOI), indium antimonide, a lead tellurium compound, indium arsenide, indium phosphide, gallium arsenide, or gallium antimonide, but is not limited thereto.

Each of the first active patterns AP1 and the second active patterns AP2 may be disposed on the first surface 100US of the substrate 100. Each of the first active patterns AP1 and the second active patterns AP2 may extend to be elongated along a second direction D2 on the substrate 100. The first active patterns AP1 and the second active patterns AP2 may be spaced apart from each other in a third direction D3.

Each of the first active patterns AP1 and the second active patterns AP2 may include long sides extending in the second direction D2 and short sides extending in the third direction D3. Here, the second direction D2 is not parallel to the third direction D3 and the first direction D1. In addition, the third direction D3 is not parallel to the first direction D1. The first direction D1 may be a thickness direction of the substrate 100.

Each of the first active patterns AP1 and the second active patterns AP2 may be a multi-channel active pattern. In the semiconductor device, each of the first active patterns AP1 and the second active patterns AP2 may be, for example, a fin-shaped pattern. Each of the first active patterns AP1 and the second active patterns AP2 may be used as the channel region of the transistor. It has been illustrated that the number of each of first active patterns AP1 and second active pattern AP2 is three, but this is only for convenience of explanation, and the present disclosure is not limited thereto. The number of each of first active patterns AP1 and second active pattern AP2 may be one or more.

The first active patterns AP1 and the second active patterns AP2 may be portions of the substrate 100, respectively, and may include epitaxial layers grown from the substrate 100. The first active pattern AP1 and the second active pattern AP2 may include, for example, silicon or germanium, which is an elemental semiconductor material. In addition, the first active pattern AP1 and the second active pattern AP2 may include a compound semiconductor, for example, a group IV-IV compound semiconductor or a group III-V compound semiconductor.

The group IV-IV compound semiconductor may be, for example, a binary compound or a ternary compound including two or more of carbon (C), silicon (Si), germanium (Ge), and tin (Sn), or a compound obtained by doping carbon (C), silicon (Si), germanium (Ge), and tin (Sn) with a group IV element.

The group III-V compound semiconductor may be, for example, one of a binary compound, a ternary compound, or a quaternary compound formed by combining at least one of aluminum (Al), gallium (Ga), and indium (In), which are group III elements, with one of phosphorus (P), arsenic (As), and antimony (Sb), which are group V elements, with each other.

In some implementations, the first active pattern AP1 and the second active pattern AP2 may include the same material. For example, each of the first active pattern AP1 and the second active pattern AP2 may be a silicon fin-shaped pattern. Alternatively, for example, each of the first active pattern AP1 and the second active pattern AP2 may be a fin-shaped pattern including a silicon-germanium pattern. As another example, the first active pattern AP1 and the second active pattern AP2 may include different materials. For example, some of the first active patterns AP1 and the second active patterns AP2 may be silicon fin-shaped patterns, and the others of the first active patterns AP1 and the second active patterns AP2 may be fin-shaped patterns including silicon-germanium patterns.

A field insulating film 105 is formed on the substrate 100. The field insulating film 105 is formed on the first surface 100US of the substrate 100. The field insulating film 105 may be disposed on a buried conductive pattern 115 to be described later. The field insulating film 105 may cover an upper surface of the buried conductive pattern 115.

In some implementations, a bottom surface of the field insulating film 105 defining the buried conductive pattern 115 may be flat. For example, the bottom surface of the field insulating film 105 defining the buried conductive pattern 115 may be coplanar with the first surface 100US of the substrate 100. However, implementations of the present disclosure is not limited thereto.

The field insulating film 105 covers sidewalls of the first active patterns AP1 and sidewalls of the second active patterns AP2. The field insulating film 105 may include, for example, an oxide film, a nitride film, an oxynitride film, or a combination thereof. It has been illustrated that the field insulating film 105 is a single film, but the present disclosure is not limited thereto. Although not illustrated, the field insulating film 105 may include a field liner extending along sidewalls and bottom surfaces of fin trenches defining the first and second active patterns AP1 and AP2 and a field filling film disposed on the field liner.

The plurality of gate electrodes 120 may be disposed on the substrate 100. For example, the plurality of gate electrodes 120 may be disposed on the field insulating film 105. Each of the plurality of gate electrodes 120 may extend in the third direction D3. The plurality of gate electrodes 120 may be spaced apart from each other in the second direction D2.

The plurality of gate electrodes 120 may be disposed on the first active patterns AP1 and the second active patterns AP2. The plurality of gate electrodes 120 may cover the first active patterns AP1 and the second active patterns AP2. The plurality of gate electrodes 120 may cross the first active patterns AP1 and the second active patterns AP2. Each of the plurality of gate electrodes 120 may include long sides extending in the third direction D3 and short sides extending in the second direction D2.

In FIGS. 3 and 4, an upper surface of each of the plurality of gate electrodes 120 may be a convex curved surface recessed toward an upper surface of the first active pattern AP1, but is not limited thereto. That is, Although not illustrated in FIGS. 3 and 4, the upper surface of each of the plurality of gate electrodes 120 may be a flat plane.

The plurality of gate electrodes 120 may include, for example, at least one of titanium nitride (TiN), tantalum carbide (TaC), tantalum nitride (TaN), titanium silicon nitride (TiSiN), tantalum silicon nitride (TaSiN), tantalum titanium nitride (TaTiN), titanium aluminum nitride (TiAlN), tantalum aluminum nitride (TaAlN), tungsten nitride (WN), ruthenium (Ru), titanium aluminum (TiAl), titanium aluminum carbonitride (TiAlC-N), titanium aluminum carbide (TiAlC), titanium carbide (TiC), tantalum carbonitride (TaCN), tungsten (W), aluminum (Al), copper (Cu), cobalt (Co), titanium (Ti), tantalum (Ta), nickel (Ni), platinum (Pt), nickel platinum (Ni-Pt), niobium (Nb), niobium nitride (NbN), niobium carbide (NbC), molybdenum (Mo), molybdenum nitride (MoN), molybdenum carbide (MoC), tungsten carbide (WC), rhodium (Rh), palladium (Pd), iridium (Ir), osmium (Os), silver (Ag), gold (Au), zinc (Zn), vanadium (V), and combinations thereof.

Each of the plurality of gate electrodes 120 may include conductive metal oxide, conductive metal oxynitride, or the like, and may include a form in which the above-described material is oxidized.

The plurality of gate electrodes 120 may be disposed on both sides of a first source/drain pattern 150 to be described later. Although not illustrated, the plurality of gate electrodes 120 may be disposed on both sides of a second source/drain pattern 250.

As an example, both of the gate electrodes 120 disposed on both sides of the first source/drain pattern 150 or both sides of the second source/drain pattern 250 may be normal gate electrodes used as gates of the transistor. As another example, the gate electrode 120 disposed on one side of the first source/drain pattern 150 or one side of the second source/drain pattern 250 may be used as a gate of the transistor, but the gate electrode 120 disposed on the other side of the first source/drain pattern 150 or the other side of the second source/drain pattern 250 may be a dummy gate electrode.

A plurality of gate spacers 140 may be disposed on sidewalls of each of the plurality of gate electrodes 120. The plurality of gate spacers 140 are not in contact with the plurality of gate electrodes 120. A gate insulating film 130 may be disposed between the gate spacer 140 and the sidewalls of the gate electrode 120. Each of the plurality of gate spacers 140 may extend in the third direction D3. The plurality of gate spacers 140 may include, for example, at least one of silicon nitride (SiN), silicon oxynitride (SiON), silicon oxide (SiO₂), silicon oxycarbonitride (SiOCN), silicon boron nitride (SiBN), silicon oxyboron nitride (SiOBN), silicon oxycarbide (SiOC), and combinations thereof.

The gate insulating film 130 may extend along the sidewalls and a bottom surface of each of the plurality of gate electrodes 120. The gate insulating film 130 may be formed on the first active patterns AP1, the second active patterns AP2, and the field insulating film 105. The gate insulating film 130 may be formed between the plurality of gate electrodes 120 and the plurality of gate spacers 140.

The gate insulating film 130 may include silicon oxide, silicon oxynitride, silicon nitride, or a high-k material having a dielectric constant greater than that of the silicon oxide. The high-k material may include, for example, one or more of boron nitride, hafnium oxide, hafnium silicon oxide, hafnium aluminum oxide, lanthanum oxide, lanthanum aluminum oxide, zirconium oxide, zirconium silicon oxide, tantalum oxide, titanium oxide, barium strontium titanium oxide, barium titanium oxide, strontium titanium oxide, yttrium oxide, aluminum oxide, lead scandium tantalum oxide, or lead zinc niobate.

It has been illustrated that the gate insulating film 130 is a single film, but this is only for convenience of explanation, and the present disclosure is not limited thereto. The gate insulating film 130 may include a plurality of films. The gate insulating film 130 may include an interfacial layer and a high-k insulating film disposed between the first active patterns AP1 and the gate electrodes 120 and between the second active patterns AP2 and the plurality of gate electrodes 120.

The semiconductor device may include a negative capacitance (NC) FET using a negative capacitor. For example, the gate insulating film 130 may include a ferroelectric material film having ferroelectric characteristics and a paraelectric material film having paraelectric characteristics.

The ferroelectric material film may have a negative capacitance, and the paraelectric material film may have a positive capacitance. For example, when two or more capacitors are connected to each other in series and a capacitance of each capacitor has a positive value, a total capacitance decreases as compared with a capacitance of each individual capacitor. On the other hand, when at least one of capacitances of two or more capacitors connected to each other in series has a negative value, a total capacitance may have a positive value and be greater than an absolute value of each individual capacitance.

When the ferroelectric material film having the negative capacitance and the paraelectric material film having the positive capacitance are connected to each other in series, a total capacitance value of the ferroelectric material film and the paraelectric material film connected to each other in series may increase. A transistor including the ferroelectric material film may have a subthreshold swing (SS) less than 60 mV/decade at room temperature using the increase in the total capacitance value.

The ferroelectric material film may include, for example, at least one of hafnium oxide, hafnium zirconium oxide, barium strontium titanium oxide, barium titanium oxide, and lead zirconium titanium oxide. Here, as an example, the hafnium zirconium oxide may be a material obtained by doping hafnium oxide with zirconium (Zr). As another example, the hafnium zirconium oxide may be a compound of hafnium (Hf), zirconium (Zr), and oxygen (O).

The ferroelectric material film may further include a dopant. For example, the dopant may include at least one of aluminum (Al), titanium (Ti), niobium (Nb), lanthanum (La), yttrium (Y), magnesium (Mg), silicon (Si), calcium (Ca), cerium (Ce), dysprosium (Dy), erbium (Er), gadolinium (Gd), germanium (Ge), scandium (Sc), strontium (Sr), and tin (Sn). A type of dopant included in the ferroelectric material film may change depending on a type of ferroelectric material included in the ferroelectric material film.

When the ferroelectric material film includes the hafnium oxide, the dopant included in the ferroelectric material film may include, for example, at least one of gadolinium (Gd), silicon (Si), zirconium (Zr), aluminum (Al), and yttrium (Y).

When the dopant is aluminum (Al), the ferroelectric material film may include 3 to 8 atomic % (at%) of aluminum. Here, a ratio of the dopant may be a ratio of aluminum to the sum of hafnium and aluminum.

When the dopant is silicon (Si), the ferroelectric material film may include 2 to 10 at% of silicon. When the dopant is yttrium (Y), the ferroelectric material film may include 2 to 10 at% of yttrium. When the dopant is gadolinium (Gd), the ferroelectric material film may include 1 to 7 at% of gadolinium. When the dopant is zirconium (Zr), the ferroelectric material film may include 50 to 80 at% of zirconium.

The paraelectric material film may have the paraelectric characteristics. The paraelectric material film may include, for example, at least one of silicon oxide and metal oxide having a high dielectric constant. The metal oxide included in the paraelectric material film may include, for example, at least one of hafnium oxide, zirconium oxide, and aluminum oxide, but is not limited thereto.

The ferroelectric material film and the paraelectric material film may include the same material. The ferroelectric material film may have the ferroelectric characteristics, but the paraelectric material film may not have the ferroelectric characteristics. For example, when the ferroelectric material film and the paraelectric material film include hafnium oxide, a crystal structure of the hafnium oxide included in the ferroelectric material film is different from a crystal structure of the hafnium oxide included in the paraelectric material film.

The ferroelectric material film may have a thickness sufficient to exhibit ferroelectric characteristics. The thickness of the ferroelectric material film may be, for example, 0.5 to 10 nm, but is not limited thereto. Since a critical thickness representing the ferroelectric characteristics may change for each ferroelectric material, the thickness of the ferroelectric material film may change depending on a ferroelectric material.

As an example, the gate insulating film 130 may include one ferroelectric material film. As another example, the gate insulating film 130 may include a plurality of ferroelectric material films spaced apart from each other. The gate insulating film 130 may have a stacked film structure in which a plurality of ferroelectric material films and a plurality of paraelectric material films are alternately stacked.

A plurality of gate capping films 145 may be disposed on the upper surfaces of the plurality of gate electrodes 120 and upper surfaces of the plurality of gate spacers 140, respectively. The plurality of gate capping films 145 may include, for example, at least one of silicon nitride (SiN), silicon oxynitride (SiON), silicon oxide (SiO₂), silicon carbonitride (SiCN), silicon oxycarbonitride (SiOCN), and combinations thereof.

The first source/drain patterns 150 may be disposed on the substrate 100. The first source/drain patterns 150 may be formed on the first active patterns AP1. The first source/drain patterns 150 are connected to the first active patterns AP1. Bottom surfaces of the first source/drain patterns 150 are in contact with the first active patterns AP1.

The first source/drain patterns 150 may be disposed on side surfaces of each of the plurality of gate electrodes 120. The first source/drain patterns 150 may be disposed between the plurality of gate electrodes 120.

For example, the first source/drain patterns 150 may be disposed on both sides of the plurality of gate electrodes 120. Although not illustrated, the first source/drain patterns 150 may be disposed on one sides of the plurality of gate electrodes 120 and may not be disposed on the other sides of the plurality of gate electrodes 120.

The first source/drain pattern 150 may include an epitaxial pattern. The first source/drain pattern 150 may include a semiconductor material. The first source/drain pattern 150 may be included in a source/drain of the transistor using the first active pattern AP1 as the channel region.

The first source/drain pattern 150 may be connected to the channel region used as a channel in the first active pattern AP1. It has been illustrated that three epitaxial patterns formed on each of the first active patterns AP1 are merged with each other as the first source/drain patterns 150, but this is only for convenience of explanation, but the present disclosure is not limited thereto. That is, the epitaxial patterns formed on each of the first active patterns AP1 may be separated from each other.

As an example, an air gap may be disposed in a space between the first source/drain patterns 150 merged with the field insulating film 105. As another example, an insulating material may be filled in a space between the first source/drain patterns 150 merged with the field insulating film 105.

The second source/drain patterns 250 may be disposed on the substrate 100. The second source/drain patterns 250 may be formed on the second active patterns AP2. The second source/drain patterns 250 are connected to the second active patterns AP2. Bottom surfaces of the second source/drain patterns 250 are in contact with the second active patterns AP2.

The second source/drain patterns 250 may be disposed on side surfaces of each of the plurality of gate electrodes 120. The second source/drain patterns 250 may be disposed between the plurality of gate electrodes 120.

For example, the second source/drain patterns 250 may be disposed on both sides of the plurality of gate electrodes 120. Although not illustrated, the second source/drain patterns 250 may be disposed on one side of the plurality of gate electrodes 120 and may not be disposed on the other sides of the plurality of gate electrodes 120.

The second source/drain pattern 250 may include an epitaxial pattern. The second source/drain pattern 250 may include a semiconductor material. The second source/drain pattern 250 may be included in a source/drain of a transistor using the second active pattern AP2 as a channel region.

The second source/drain pattern 250 may be connected to the channel region used as a channel in the second active pattern AP2. Three epitaxial patterns formed on each of the second active patterns AP2 are merged with each other as the second source/drain patterns 250 has been illustrated, but this is only for convenience of explanation, and the present disclosure is not limited thereto. That is, the epitaxial patterns formed on each of the second active patterns AP2 may be separated from each other.

As an example, an air gap may be disposed in a space between the second source/drain patterns 250 merged with the field insulating film 105. As another example, an insulating material may be filled in a space between the second source/drain patterns 250 merged with the field insulating film 105.

An etch stop film 160 may extend along an upper surface of the field insulating film 105, sidewalls of the plurality of gate spacers 140, and profiles of the first source/drain pattern 150 and the second source/drain pattern 250. The etch stop film 160 may be disposed on an upper surface of the first source/drain pattern 150, sidewalls of the first source/drain pattern 150, an upper surface of the second source/drain pattern 250, sidewalls of the second source/drain pattern 250, and the sidewalls of the plurality of gate spacers 140. In some implementations, the etch stop film 160 is not disposed on sidewalls of the gate capping film 145. That is, the gate capping film 145 may be disposed on an upper surface of the etch stop film 160. In addition, sidewalls of the etch stop film 160 may be connected to outer sidewalls of the gate capping film 145. Although not illustrated, the etch stop film 160 may also be disposed on the sidewalls of the gate capping film 145.

The etch stop film 160 may include a material having an etch selectivity with respect to a first interlayer insulating film 190 to be described later. The etch stop film 160 may include a nitride-based insulating material. For example, the etch stop film 160 may include at least one of silicon nitride (SiN), silicon oxynitride (SiON), silicon oxycarbonitride (SiOCN), silicon boron nitride (SiBN), silicon oxyboronitride (SiOBN), and combinations thereof.

The first interlayer insulating film 190 is disposed on the etch stop film 160. The first interlayer insulating film 190 may be formed on the field insulating film 105. The first interlayer insulating film 190 may be disposed on the first source/drain pattern 150 and the second source/drain pattern 250. The first interlayer insulating film 190 may not cover an upper surface of the gate capping film 145. For example, an upper surface of the first interlayer insulating film 190 may be coplanar with the upper surface of the gate capping film 145.

The first interlayer insulating film 190 may include, for example, at least one of silicon oxide, silicon nitride, silicon oxynitride, and a low-k material. The low-k material may include, for example, fluorinated tetraethylorthosilicate (FTEOS), hydrogen silsesquioxane (HSQ), bis-benzocyclobutene (BCB), tetramethylorthosilicate (TMOS), octamethylcyclotetrasiloxane (OMCTS), hexamethyldisiloxane (HMDS), trimethylsilyl borate (TMSB), diacetoxyditertiarybutosiloxane (DADBS), trimethylsilyl phosphate (TMSP), polytetrafluoroethylene (PTFE), tonen silazen (TOSZ), fluoride silicate glass (FSG), polyimide nanofoams such as polypropylene oxide, carbon doped silicon oxide (CDO), organo silicate glass (OSG), SiLK, amorphous fluorinated carbon, silica aerogels, silica xerogels, mesoporous silica, or combinations thereof, but is not limited thereto.

The first source/drain contact 170 may be disposed on the first source/drain pattern 150 on the first active pattern AP1. The second source/drain contact 270 may be disposed on the second source/drain pattern 250 on the second active pattern AP2. The first source/drain contact 170 may be connected to the first source/drain pattern 150. The second source/drain contact 270 may be connected to the second source/drain pattern 250.

The gate contacts 180 may be connected to some of the plurality of gate electrodes 120. The gate contacts 180 may be disposed at positions overlapping the plurality of gate electrodes 120.

The first source/drain contact 170 may penetrate through the etch stop film 160 and be connected to the first source/drain pattern 150. The first source/drain contact 170 may be disposed on the first source/drain pattern 150.

The first source/drain contact 170 may be disposed within the first interlayer insulating film 190. The first source/drain contact 170 may be surrounded by the first interlayer insulating film 190.

A first contact silicide film 155 may be disposed between the first source/drain contact 170 and the first source/drain pattern 150. The first contact silicide film 155 being formed along a profile of an interface between the first source/drain pattern 150 and the first source/drain contact 170 has been illustrated, but the present disclosure is not limited thereto. The first contact silicide film 155 may include, for example, a metal silicide material.

The first interlayer insulating film 190 does not cover an upper surface of the first source/drain contact 170. As an example, the upper surface of the first source/drain contact 170 may not protrude above the upper surface of the gate capping film 145. The upper surface of the first source/drain contact 170 may be coplanar with the upper surface of the gate capping film 145. Although not illustrated, as another example, the upper surface of the first source/drain contact 170 may protrude above the upper surface of the gate capping film 145.

In addition, the upper surface of the first source/drain contact 170 may be coplanar with an upper surface of the gate contact 180. The upper surface of the first source/drain contact 170 may be coplanar with an upper surface of the power rail via PVA.

In some implementations, the first source/drain contact 170 may include a first source/drain barrier film 170a and a first source/drain filling film 170b disposed on the first source/drain barrier film 170a.

A bottom surface of the first source/drain contact 170 having a flat shape has been illustrated, but the present disclosure is not limited thereto. Although not illustrated, the bottom surface of the first source/drain contact 170 may have a wavy shape.

The first source/drain barrier film 170a may include, for example, at least one of tantalum (Ta), tantalum nitride (TaN), titanium (Ti), titanium nitride (TiN), titanium silicon nitride (TiSiN), ruthenium (Ru), cobalt (Co), nickel (Ni), nickel boron (NiB), tungsten (W), tungsten nitride (WN), tungsten carbonitride (WCN), zirconium (Zr), zirconium nitride (ZrN), vanadium (V), vanadium nitride (VN), niobium (Nb), niobium nitride (NbN), platinum (Pt), iridium (Ir), rhodium (Rh), and a two-dimensional (2D) material. In the semiconductor device, the 2D material may be a metallic material and/or a semiconductor material. The 2D material may include a 2D allotrope or a 2D compound, for example, at least one of graphene, molybdenum disulfide (MoS₂), molybdenum diselenide (MoSe₂), tungsten diselenide (WSe₂), and tungsten disulfide (WS₂), but is not limited thereto. That is, the above-described 2D materials have been enumerated only as an example, and thus, the 2D material that may be included in the semiconductor device according to the present disclosure is not limited by the above-described materials.

The first source/drain filling film 170b may include, for example, at least one of aluminum (Al), tungsten (W), cobalt (Co), ruthenium (Ru), silver (Ag), gold (Au), manganese (Mn), copper (Cu), and molybdenum (Mo).

The first source/drain contact 170 including a plurality of conductive films has been illustrated, but the present disclosure is not limited thereto. Although not illustrated, the first source/drain contact 170 may be a single film.

The second source/drain contact 270 may penetrate through the etch stop film 160 and be connected to the second source/drain pattern 250. The second source/drain contact 270 may be disposed on the second source/drain pattern 250.

The second source/drain contact 270 may be disposed within the first interlayer insulating film 190. The second source/drain contact 270 may be surrounded by the first interlayer insulating film 190.

A second contact silicide film 255 may be disposed between the second source/drain contact 270 and the second source/drain pattern 250. It has been illustrated that the second contact silicide film 255 is formed along a profile of an interface between the second source/drain pattern 250 and the second source/drain contact 270, but the present disclosure is not limited thereto. The second contact silicide film 255 may include, for example, a metal silicide material.

The first interlayer insulating film 190 does not cover an upper surface of the second source/drain contact 270. As an example, the upper surface of the second source/drain contact 270 may not protrude above the upper surface of the gate capping film 145. The upper surface of the second source/drain contact 270 may be coplanar with the upper surface of the gate capping film 145. Although not illustrated, as another example, the upper surface of the second source/drain contact 270 may protrude above the upper surface of the gate capping film 145.

In addition, the upper surface of the second source/drain contact 270 may be coplanar with the upper surface of the gate contact 180. The upper surface of the second source/drain contact 270 may be coplanar with the upper surface of the power rail via PVA.

In some implementations, the second source/drain contact 270 may include a second source/drain barrier film 270a and a second source/drain filling film 270b disposed on the second source/drain barrier film 270a.

A bottom surface of the second source/drain contact 270 having a flat shape has been illustrated, but the present disclosure is not limited thereto. Although not illustrated, the bottom surface of the second source/drain contact 270 may have a wavy shape.

A material included in the second source/drain barrier film 270a may be the same as the material included in the first source/drain barrier film 170a. A material included in the second source/drain filling film 270b may be the same as the material included in the first source/drain filling film 170b.

The second source/drain contact 270 including a plurality of conductive films has been illustrated, but the present disclosure is not limited thereto. Although not illustrated, the second source/drain contact 270 may be a single film.

The gate contact 180 may be disposed on the gate electrode 120. The gate contact 180 may penetrate through the gate capping film 145 and be connected to the gate electrode 120.

As an example, the upper surface of the gate contact 180 may be coplanar with the upper surface of the gate capping film 145. Although not illustrated, as another example, the upper surface of the gate contact 180 may protrude above the upper surface of the gate capping film 145.

The gate contact 180 may include a gate barrier film 180a and a gate filling film 180b disposed on the gate barrier film 180a. Descriptions of materials included in the gate barrier film 180a and the gate filling film 180b may be the same as those of the materials included in the first source/drain barrier film 170a and the first source/drain filling film 170b, respectively.

The gate contact 180 including a plurality of conductive films has been illustrated, but the present disclosure is not limited thereto. Although not illustrated, the gate contact 180 may be a single film.

The semiconductor device may further include a lower insulating film 102. The lower insulating film 102 may be disposed on the second surface 100BS of the substrate 100. The lower insulating film 102 may be in contact with the second surface 100BS of the substrate 100.

The lower insulating film 102 may include, for example, at least one of silicon oxide, silicon nitride, silicon oxynitride, and a low-k material. The low-k material may include, for example, fluorinated tetraethylorthosilicate (FTEOS), hydrogen silsesquioxane (HSQ), bis-benzocyclobutene (BCB), tetramethylorthosilicate (TMOS), octamethylcyclotetrasiloxane (OMCTS), hexamethyldisiloxane (HMDS), trimethylsilyl borate (TMSB), diacetoxyditertiarybutosiloxane (DADBS), trimethylsilyl phosphate (TMSP), polytetrafluoroethylene (PTFE), tonen silazen (TOSZ), fluoride silicate glass (FSG), polyimide nanofoams such as polypropylene oxide, carbon doped silicon oxide (CDO), organo silicate glass (OSG), SiLK, amorphous fluorinated carbon, silica aerogels, silica xerogels, mesoporous silica, or combinations thereof, but is not limited thereto.

The power rail PR may be disposed between the first active pattern AP1 and the second active pattern AP2. The power rail PR may be disposed within the lower insulating film 102. The lower insulating film 102 may surround the power rail PR. The power rail PR may extend to be elongated in the second direction D2, but is not limited thereto.

The power rail PR is disposed on the second surface 100BS of the substrate 100. The power rail PR is disposed within the lower insulating film 102. The power rail PR may be in contact with a bottom surface of the buried conductive pattern 115. The power rail PR may be electrically connected to the buried conductive pattern 115.

In some implementations, the power rail PR may be connected to the first source/drain pattern 150. For example, the power rail PR may be connected to the first source/drain pattern 150 through the buried conductive pattern 115, the power rail via PVA, a first via plug 195, and the first source/drain contact 170. A voltage may be applied to the first source/drain pattern 150 through the power rail PR.

In some implementations, the power rail PR may include a power rail barrier film PR_a and a power rail filling film PR_b disposed on the power rail barrier film PR_a. Descriptions of materials included in the power rail barrier film PR_a and the power rail filling film PR_b may be the same as those of the materials included in the first source/drain barrier film 170a and the first source/drain filling film 170b, respectively. It has been illustrated that the power rail PR includes a plurality of conductive films, but the present disclosure is not limited thereto. Although not illustrated, the power rail PR may be a single film.

In some implementations, the buried conductive pattern 115 may be disposed within the substrate 100. The buried conductive pattern 115 may be disposed on the power rail PR. The buried conductive pattern 115 may be interposed between the power rail PR and the power rail via PVA. The buried conductive pattern 115 may be connected to the power rail PR and the power rail via PVA.

In some implementations, the bottom surface of the buried conductive pattern 115 may be coplanar with the second surface 100BS of the substrate 100. The bottom surface of the buried conductive pattern 115 may extend in parallel with the second surface 100BS of the substrate 100.

In FIGS. 2 and 4, a width of the buried conductive pattern 115 in the third direction D3 may gradually decrease from the second surface 100BS of the substrate 100 toward the first surface 100US of the substrate 100. In FIG. 4, a width of the buried conductive pattern 115 in the second direction D2 may gradually decrease from the second surface 100BS of the substrate 100 toward the first surface 100US of the substrate 100.

The buried conductive pattern 115 may include a buried conductive pattern barrier film 115a and a buried conductive pattern filling film 115b disposed on the buried conductive pattern barrier film 115a. Descriptions of materials included in the buried conductive pattern barrier film 115a and the buried conductive pattern filling film 115b may be the same as those of the materials included in the first source/drain barrier film 170a and the first source/drain filling film 170b, respectively. Although not illustrated, the buried conductive pattern 115 may be a single film.

The semiconductor device further includes a via trench PVA_T penetrating through the first interlayer insulating film 190 and the field insulating film 105.

The via trench PVA_T may be defined by via insulating liners 110 to be described later. The via trench PVA_T may expose the buried conductive pattern 115. The via trench PVA_T may expose the upper surface of the buried conductive pattern 115. The via trench PVA_T may be disposed on the buried conductive pattern 115. The via trench PVA_T may be disposed between the plurality of gate electrodes 120. The via trench PVA_T may be disposed between the first active pattern AP1 and the second active pattern AP2. The via trench PVA_T may be disposed between the first source/drain pattern 150 and the second source/drain pattern 250. The via trench PVA_T may be disposed between the first source/drain contact 170 and the second source/drain contact 270. The via trench PVA_T may penetrate through the first interlayer insulating film 190, the etch stop film 160, and penetrates through the field insulating film 105.

A via insulating liner 110 is disposed on outer sidewalls of the via trench PVA_T. The via insulating liner 110 extends along sidewalls of a power rail via PVA to be described later. The via insulating liner 110 may be interposed between the power rail via PVA and the first source/drain pattern 150. The via insulating liner 110 may be interposed between the power rail via PVA and the first source/drain contact 170. The via insulating liner 110 may be interposed between the power rail via PVA and the second source/drain pattern 250. The via insulating liner 110 may be interposed between the power rail via PVA and the second source/drain contact 270. The via insulating liner 110 includes an insulating material. As an example, the via insulating liner 110 may be formed as a silicon oxide film, but the present disclosure is not limited thereto.

In some implementations, the via insulating liner 110 does not protrude above the upper surface of the first interlayer insulating film 190. For example, the via insulating liner 110 may not protrude above the upper surface of the first source/drain contact 170 and the upper surface of the second source/drain contact 270.

The power rail via PVA is disposed within the via trench PVA_T. The power rail via PVA may be interposed between the via insulating liners 110. The power rail via PVA may be disposed on the power rail PR. The power rail via PVA may be disposed on the buried conductive pattern 115. The power rail via PVA may be connected to the power rail PR through the buried conductive pattern 115. The power rail via PVA may be disposed between the plurality of gate electrodes 120. In addition, the power rail via PVA may be disposed between the first active pattern AP1 and the second active pattern AP2. The power rail via PVA may be disposed between the first source/drain pattern 150 and the second source/drain pattern 250. The power rail via PVA may also be disposed between the first source/drain contact 170 and the second source/drain contact 270.

The power rail via PVA may penetrate through the first interlayer insulating film 190, the etch stop film 160, and the field insulating film 105 and be connected to the buried conductive pattern 115. A bottom surface of the power rail via PVA may be in contact with the upper surface of the buried conductive pattern 115.

The first interlayer insulating film 190 may not cover the upper surface of the power rail via PVA. For example, the upper surface of the power rail via PVA and the upper surface of the first interlayer insulating film 190 may be coplanar with each other. In addition, the upper surface of the power rail via PVA may be coplanar with the upper surface of the first source/drain contact 170 and the upper surface of the second source/drain contact 270. In addition, the upper surface of the power rail via PVA may be coplanar with the upper surface of the gate contact 180 and the upper surface of the gate capping film 145.

The power rail via PVA includes a first sub-film PVA_1 and a second sub-film PVA_2. The first sub-film PVA_1 is disposed at a lower portion of the via trench PVA_T. The second sub-film PVA_2 is disposed at an upper portion of the via trench PVA_T. That is, the second sub-film PVA_2 is disposed on the first sub-film PVA_1. The first sub-film PVA_1 may be connected to the buried conductive pattern 115, and the second sub-film PVA_2 may be connected to the first via plug 195. Alternatively, the first sub-film PVA_1 may be connected to the buried conductive pattern 115, and the second sub-film PVA_2 may be connected to the first source/drain contact 170.

The first sub-film PVA_1 is formed as a single film, e.g., a single continuous film of a single material. The first sub-film PVA_1 may be interposed between the via insulating liners 110. Sidewalls of the first sub-film PVA_1 may be in contact with the via insulating liners 110. A bottom surface of the first sub-film PVA_1 may be in contact with the upper surface of the buried conductive pattern 115. An upper surface of the first sub-film PVA_1 may be in contact with a bottom surface of the second sub-film PVA_2.

The second sub-film PVA_2 is formed as multiple films. The second sub-film PVA_2 includes a barrier film PVA_2a and a filling film PVA_2b.

The barrier film PVA_2a of the second sub-film PVA_2 may extend along inner sidewalls of the upper portion of the via trench PVA_T. The barrier films PVA_2a of the second sub-film PVA_2 are disposed on sidewalls of the via insulating liners 110. The barrier films PVA_2a of the second sub-film PVA_2 does not extend along the upper surface of the first sub-film PVA_1. The barrier films PVA_2a of the second sub-film PVA_2 may be disposed only on the inner sidewalls of the upper portion of the via trench PVA_T.

The filling film PVA_2b of the second sub-film PVA_2 may be disposed on the barrier films PVA_2a of the second sub-film PVA_2. The filling film PVA_2b of the second sub-film PVA_2 may be disposed between the barrier films PVA_2a of the second sub-film PVA_2. A bottom surface of the filling film PVA_2b of the second sub-film PVA_2 may be in contact with the upper surface of the first sub-film PVA_1.

The power rail via PVA of the semiconductor device includes the first sub-film PVA_1 formed as the single film and the second sub-film PVA_2 formed as the multiple films. The first sub-film PVA_1 does not include a barrier film. Accordingly, resistance of the power rail via PVA may be decreased. Accordingly, performance and reliability of the semiconductor device including the power rail via PVA may be improved.

The first sub-film PVA_1 may include a conductive material. For example, the first sub-film PVA_1 may include at least one of aluminum (Al), tungsten (W), cobalt (Co), ruthenium (Ru), silver (Ag), gold (Au), manganese (Mn), copper (Cu), and molybdenum (Mo).

The barrier film PVA_2a of the second sub-film PVA_2 may include a conductive material. The barrier film PVA_2a of the second sub-film PVA_2 may include, for example, at least one of tantalum (Ta), tantalum nitride (TaN), titanium (Ti), titanium nitride (TiN), titanium silicon nitride (TiSiN), ruthenium (Ru), cobalt (Co), nickel (Ni), nickel boron (NiB), tungsten (W), tungsten nitride (WN), tungsten carbonitride (WCN), zirconium (Zr), zirconium nitride (ZrN), vanadium (V), vanadium nitride (VN), niobium (Nb), niobium nitride (NbN), platinum (Pt), iridium (Ir), rhodium (Rh), and a two-dimensional (2D) material.

The filling film PVA_2b of the second sub-film PVA_2 may include a conductive material. For example, the filling film PVA_2b of the second sub-film PVA_2 may include at least one of aluminum (Al), tungsten (W), cobalt (Co), ruthenium (Ru), silver (Ag), gold (Au), manganese (Mn), copper (Cu), and molybdenum (Mo).

In some implementations, the first sub-film PVA_1 and the filling film PVA_2b of the second sub-film PVA_2 may be made of the same material. In this case, a boundary between the first sub-film PVA_1 and the filling film PVA_2b of the second sub-film PVA_2 may not be apparent. In some implementations, the first sub-film PVA_1 and the filling film PVA_2b of the second sub-film PVA_2 may be made of different materials. In this case, a boundary between the upper surface of the first sub-film PVA_1 and the bottom surface of the filling film PVA_2b of the second sub-film PVA_2 may be apparent.

In FIG. 2, a height H1 from the second surface 100BS of the substrate 100 to the upper surface of the first sub-film PVA_1 is greater than a height H2 from the second surface 100BS of the substrate 100 to the upper surface of the field insulating film 105. The height H1 from the second surface 100BS of the substrate 100 to the upper surface of the first sub-film PVA_1 is greater than a height from the second surface 100BS of the substrate 100 to the upper surface of the first source/drain pattern 150 and the upper surface of the second source/drain pattern 250.

That is, the first sub-film PVA_1 overlaps the first active pattern AP1 and the second active pattern AP2 when viewed along the third direction D3. The first sub-film PVA_1 overlaps the first source/drain pattern 150 and the second source/drain pattern 250 when viewed along the third direction D3. However, at least a portion of the first sub-film PVA_1 does not overlap the first source/drain contact 170 and the second source/drain contact 270 when viewed along the third direction D3.

In addition, the barrier film PVA_2a of the second sub-film PVA_2 does not completely overlap the field insulating film 105 when viewed along the third direction D3. The barrier film PVA_2a of the second sub-film PVA_2 does not completely overlap the first active pattern AP1 and the second active pattern AP2 when viewed along the third direction D3. The barrier film PVA_2a of the second sub-film PVA_2 does not completely overlap the first source/drain pattern 150 and the second source/drain pattern 250 when viewed along the third direction D3. At least a portion of the barrier film PVA_2a of the second sub-film PVA_2 overlaps the first source/drain contact 170 and the second source/drain contact 270 when viewed along the third direction D3.

In addition, in FIG. 4, the first sub-film PVA_1 overlaps the plurality of gate electrodes 120 when viewed along the second direction D2. A portion of the first sub-film PVA_1 does not overlap the plurality of gate electrodes 120 when viewed along the second direction D2. The first sub-film PVA_1 does not overlap the gate capping film 145 when viewed along the second direction D2. However, the present disclosure is not limited thereto. At least a portion of the first sub-film PVA_1 may overlap the gate capping film 145 when viewed along the second direction D2, and the first sub-film PVA_1 may completely overlap the plurality of gate electrodes 120 when viewed along the second direction D2.

An upper stop film 191 may be disposed on the first interlayer insulating film 190, the gate capping film 145, the first source/drain contact 170, the second source/drain contact 270, the power rail via PVA, and the gate contact 180. A second interlayer insulating film 192 is disposed on the upper stop film 191.

The upper stop film 191 may include a material having an etch selectivity with respect to the second interlayer insulating film 192. The upper stop film 191 may include, for example, at least one of silicon nitride (SiN), silicon oxynitride (SiON), silicon oxycarbonitride (SiOCN), silicon boron nitride (SiBN), silicon oxyboron nitride (SiOBN), silicon oxycarbide (SiOC), aluminum oxide (AlO), aluminum nitride (AlN), aluminum oxycarbide (AlOC), and combinations thereof. The upper stop film 191 being a single film has been illustrated, but the present disclosure is not limited thereto. Although not illustrated, the upper stop film 191 may not be formed. The second interlayer insulating film 192 may include, for example, at least one of silicon oxide, silicon nitride, silicon carbonitride, silicon oxynitride, and a low-k material.

The first via plug 195 may be disposed within the second interlayer insulating film 192. The first via plug 195 may penetrate through the upper stop film 191 and be directly connected to the first source/drain contact 170 and the power rail via PVA.

A portion of the first via plug 195 may completely cover the upper surface of the first source/drain contact 170 and the upper surface of the power rail via PVA. That is, the first source/drain contact 170 and the power rail via PVA may be connected to one first via plug 195.

The first via plug 195 may include a first via barrier film 195a and a first via filling film 195b. The first via barrier film 195a may extend along sidewalls and a bottom surface of the first via filling film 195b. The first via barrier film 195a may include, for example, at least one of tantalum (Ta), tantalum nitride (TaN), titanium (Ti), titanium nitride (TiN), titanium silicon nitride (TiSiN), nickel (Ni), nickel boron (NiB), tungsten nitride (WN), tungsten carbonitride (WCN), zirconium (Zr), zirconium nitride (ZrN), vanadium (V), vanadium nitride (VN), niobium (Nb), niobium nitride (NbN), platinum (Pt), iridium (Ir), rhodium (Rh), and a 2D material. The first via filling film 195b may include, for example, at least one of aluminum (Al), tungsten (W), cobalt (Co), ruthenium (Ru), silver (Ag), gold (Au), manganese (Mn), copper (Cu), and molybdenum (Mo).

A second via plug 295 may be disposed within the second interlayer insulating film 192. The second via plug 295 may penetrate through the upper stop film 191 and be connected to the second source/drain contact 270. A portion of the second via plug 295 may completely cover the upper surface of the second source/drain contact 270.

The second via plug 295 may include a second via barrier film 295a and a second via filling film 295b. The second via barrier film 295a may extend along sidewalls and a bottom surface of the second via filling film 295b. A material included in the second via barrier film 295a may be the same as the material included in the first via barrier film 195a. A material included in the second via filling film 295b may be the same as the material included in the first via filling film 195b.

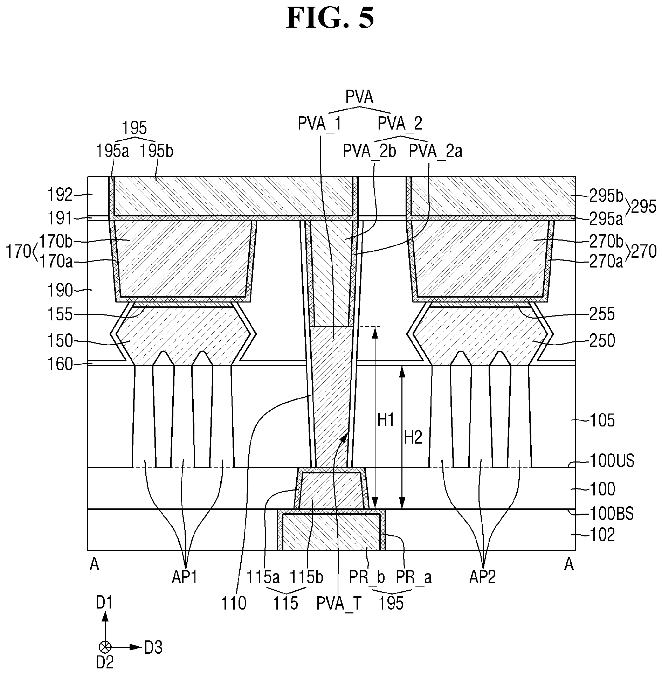

Hereinafter, more examples of semiconductor devices be described with reference to FIGS. 5 to 17. For convenience of explanation, mainly contents different from those described with reference to FIGS. 1 to 4 will be described.

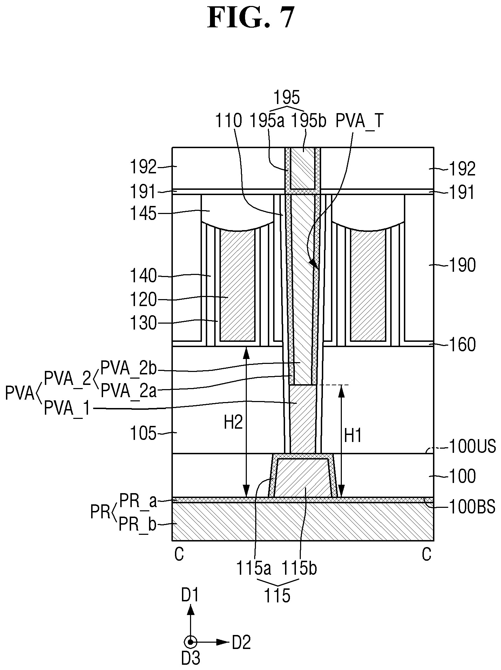

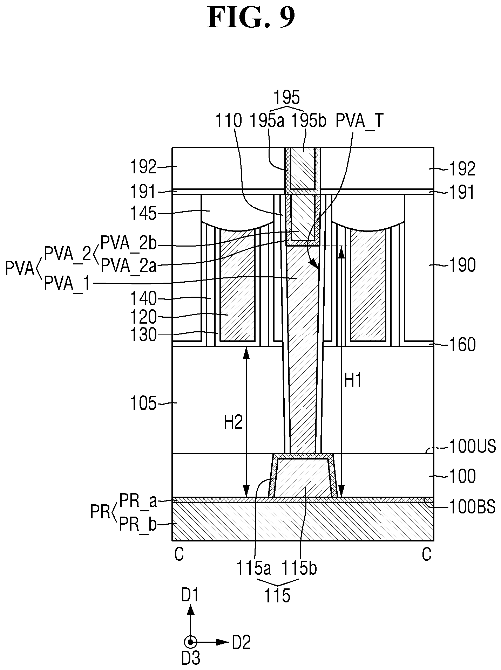

FIGS. 5 to 12 are views for describing examples of semiconductor devices. For reference, FIGS. 5, 6, 8, and 10 to 12 are illustrative cross-sectional views taken along line A-A of FIG. 1. FIGS. 7 and 9 are illustrative cross-sectional views taken along line C-C of FIG. 1.

Referring to FIG. 5, the height H1 from the second surface 100BS of the substrate 100 to the upper surface of the first sub-film PVA_1 is greater than the height H2 from the second surface 100BS of the substrate 100 to the upper surface of the field insulating film 105. On the other hand, the height H1 from the second surface 100BS of the substrate 100 to the upper surface of the first sub-film PVA_1 is smaller than a height from the second surface 100BS of the substrate 100 to the bottom surface of the first source/drain contact 170. The height H1 from the second surface 100BS of the substrate 100 to the upper surface of the first sub-film PVA_1 is smaller than a height from the second surface 100BS of the substrate 100 to the bottom surface of the second source/drain contact 270.

That is, the first sub-film PVA_1 may not completely overlap the first source/drain contact 170 and the second source/drain contact 270 when viewed along the third direction D3. At least a portion of the first sub-film PVA_1 may not overlap the first source/drain pattern 150 and the second source/drain pattern 250 when viewed along the third direction D3.

At least a portion of the barrier film PVA_2a of the second sub-film PVA_2 may overlap the first source/drain pattern 150 and the second source/drain pattern 250 when viewed along the third direction D3. Another portion of the barrier film PVA_2a of the second sub-film PVA_2 does not overlap the first source/drain pattern 150 and the second source/drain pattern 250 when viewed along the third direction D3.

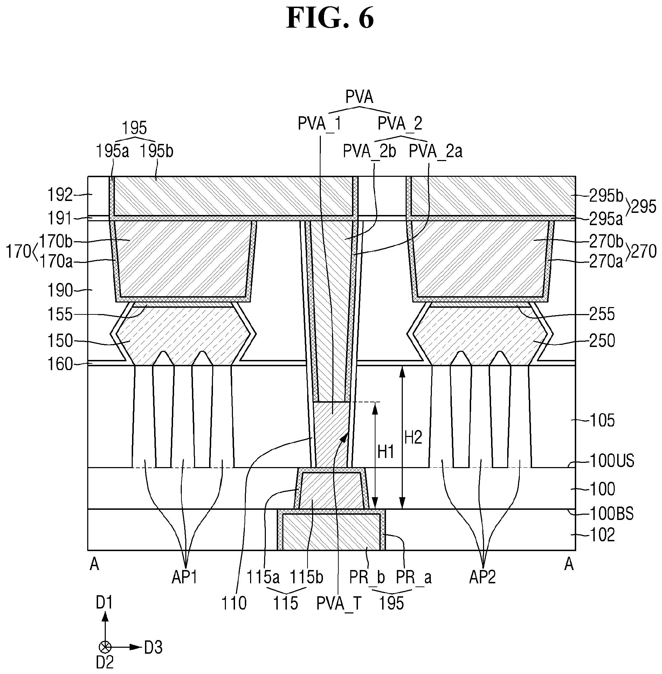

Referring to FIGS. 6 and 7, the height H1 from the second surface 100BS of the substrate 100 to the upper surface of the first sub-film PVA_1 is smaller than the height H2 from the second surface 100BS of the substrate 100 to the upper surface of the field insulating film 105.

The first sub-film PVA_1 does not penetrate through the field insulating film 105. At least a portion of the first sub-film PVA_1 does not overlap the field insulating film 105 when viewed along the third direction D3 and/or the second direction D2. At least a portion of the first sub-film PVA_1 does not overlap the first active pattern AP1 and the second active pattern AP2 when viewed along the third direction D3. The first sub-film PVA_1 does not completely overlap the plurality of gate electrodes 120 when viewed along the second direction D2.

The barrier film PVA_2a of the second sub-film PVA_2 completely overlaps the first source/drain contact 170 and the second source/drain contact 270 when viewed along the third direction D3. At least a portion of the barrier film PVA_2a of the second sub-film PVA_2 is disposed within the field insulating film 105. At least a portion of the barrier film PVA_2a of the second sub-film PVA_2 overlaps the first active pattern AP1 and the second active patterns AP2 when viewed along the third direction D3. At least a portion of the barrier film PVA_2a of the second sub-film PVA_2 does not overlap the plurality of gate electrodes 120 when viewed along the second direction D2.

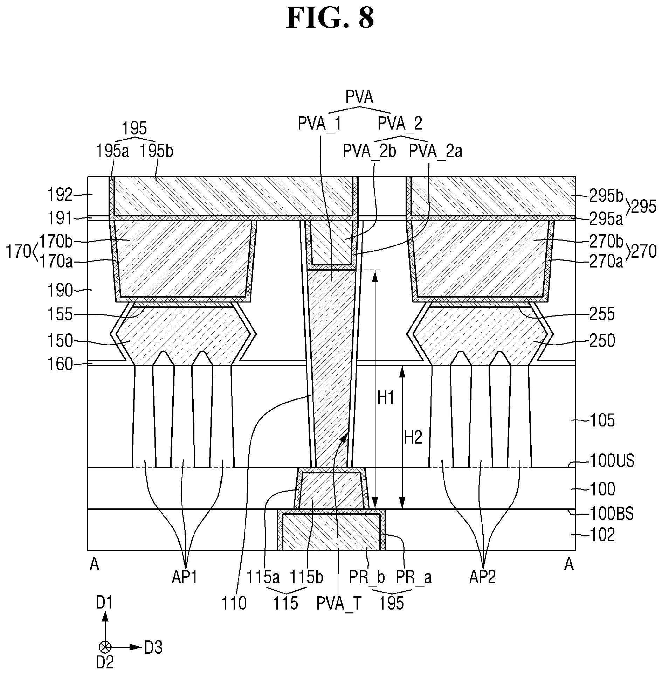

Referring to FIGS. 8 and 9, the barrier film PVA_2a of the second sub-film PVA_2 may include a portion extending along the upper surface of the first sub-film PVA_1.

For example, the barrier film PVA_2a of the second sub-film PVA_2 may be disposed in a 'U' shape within the upper portion of the via trench PVA_T. The barrier film PVA_2a of the second sub-film PVA_2 is disposed along the sidewalls of the via insulating liners 110 and the upper surface of the first sub-film PVA_1.

The filling film PVA_2b of the second sub-film PVA_2 may not be in contact with the first sub-film PVA_1. The barrier film PVA_2a of the second sub-film PVA_2 may be disposed between the filling film PVA_2b of the second sub-film PVA_2 and the first sub-film PVA_1. That is, the upper surface of the first sub-film PVA_1 may be in contact with the barrier film PVA_2a of the second sub-film PVA_2.

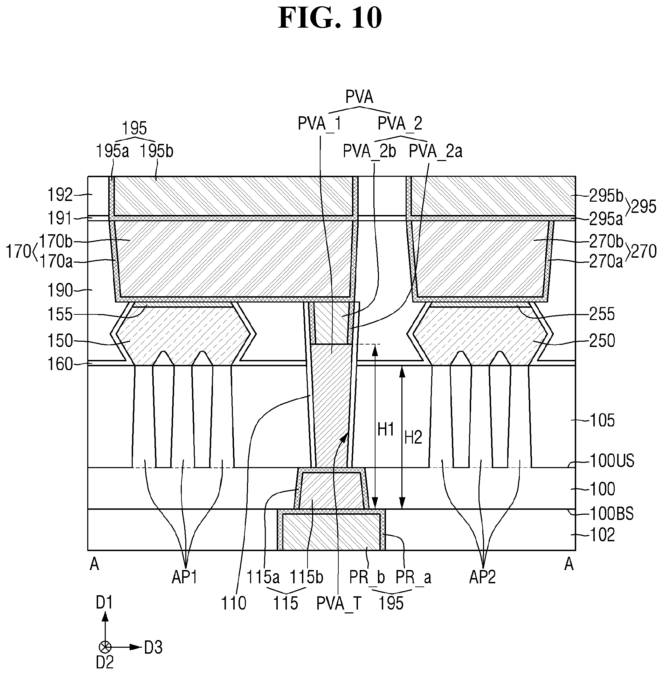

Referring to FIG. 10, the first source/drain contact 170 may extend to be elongated in the third direction D3. The first source/drain contact 170 may overlap at least a portion of the buried conductive pattern 115 when viewed along the first direction D1. The first source/drain contact 170 may overlap the power rail via PVA when viewed along the first direction D1.

In some implementations, an upper surface of the via trench PVA_T may expose the bottom surface of the first source/drain contact 170. The via trench PVA_T does not extend up to the upper surface of the first interlayer insulating film 190. The via trench PVA_T may extend from the first surface 100US of the substrate 100 to the bottom surface of the first source/drain contact 170. The bottom surface of the first source/drain contact 170 may be in contact with the upper surface of the power rail via PVA. The bottom surface of the first source/drain contact 170 may be in contact with the second sub-film PVA_2 of the power rail via PVA.

In FIG. 10, the height H1 from the second surface 100BS of the substrate 100 to the upper surface of the first sub-film PVA_1 is greater than the height H2 from the second surface 100BS of the substrate 100 to the upper surface of the field insulating film 105. However, the first sub-film PVA_1 does not overlap the first source/drain contact 170 and the second source/drain contact 270 when viewed along the third direction D3.

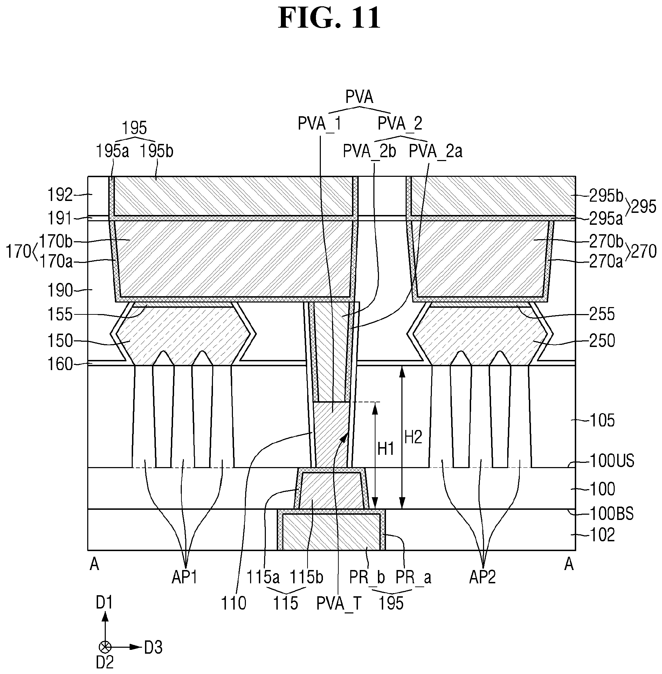

Referring to FIG. 11, the height H1 from the second surface 100BS of the substrate 100 to the upper surface of the first sub-film PVA_1 is smaller than the height H2 from the second surface 100BS of the substrate 100 to the upper surface of the field insulating film 105. The first sub-film PVA_1 does not overlap the first source/drain pattern 150 and the second source/drain pattern 250 when viewed along the third direction D3.

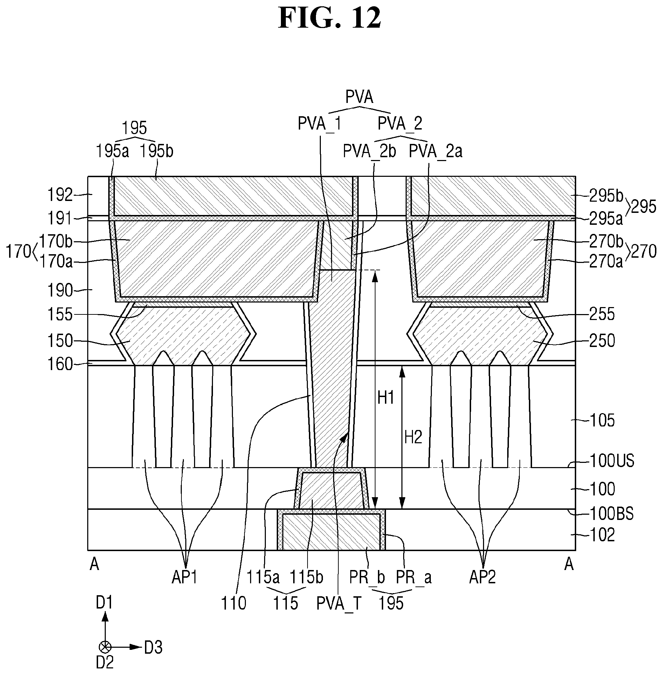

Referring to FIG. 12, a portion of the first source/drain contact 170 may be disposed within the via trench PVA_T. A portion of the first source/drain contact 170 may overlap the power rail via PVA when viewed along the first direction D1.

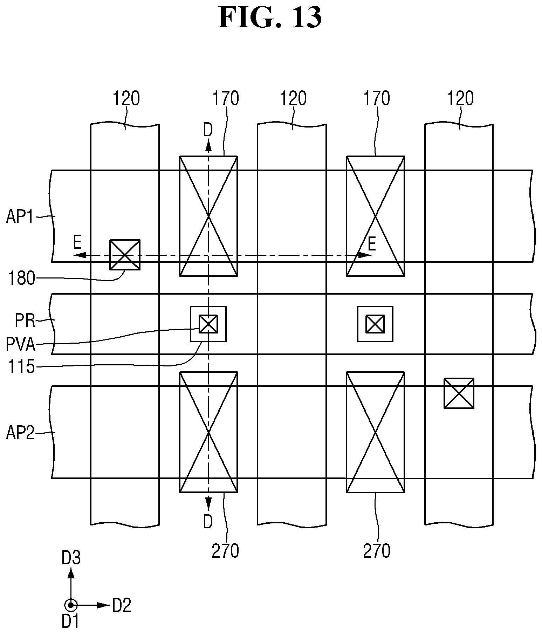

FIGS. 13 to 17 are views for describing examples of a semiconductor device.

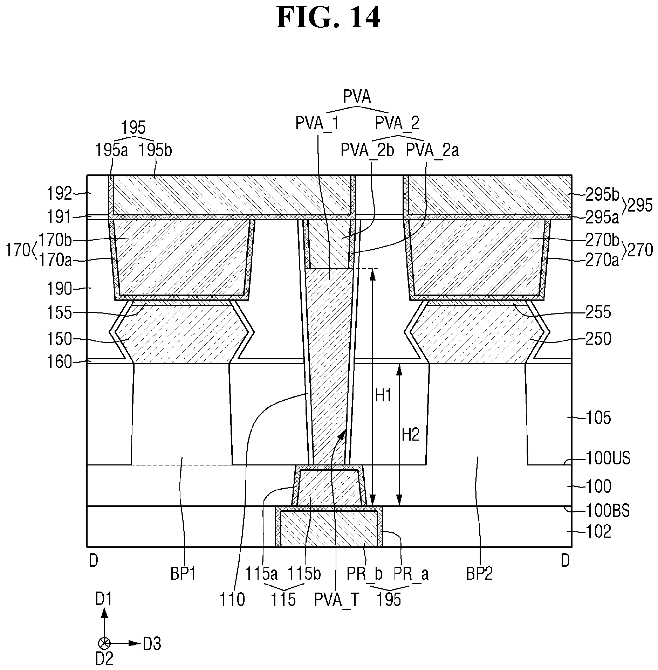

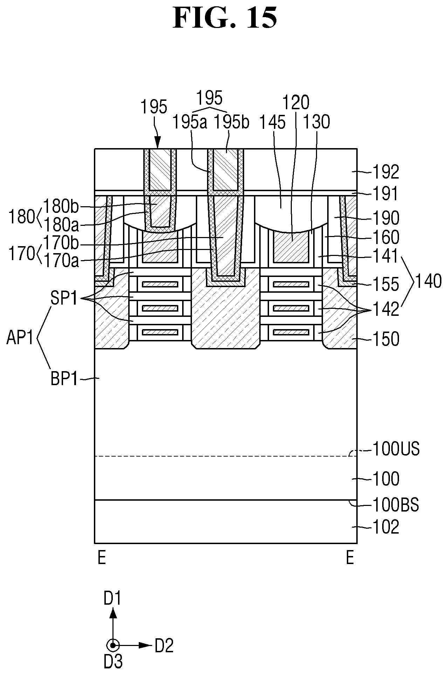

FIG. 13 is an example of a layout diagram for describing a semiconductor device. FIG. 14 is a cross-sectional view taken along line D-D of FIG. 13. FIGS. 15 to 17 are cross-sectional views taken along line E-E of FIG. 13. For convenience, mainly contents different from those described with reference to FIGS. 1 to 4 will be described.

Referring to FIGS. 13 to 17, in a semiconductor device, the first active pattern AP1 may include a first lower pattern BP1 and one or more first sheet patterns SP1. Although not illustrated, the second active pattern AP2 may include a second lower pattern BP2 and one or more second sheet patterns. Hereinafter, a description of the second lower pattern BP2 may be the same as that of the first lower pattern BP1, and will thus be omitted. In addition, a description of the second sheet pattern may be the same as that of the first sheet pattern SP1, and will thus be omitted.

Each of the first lower pattern BP1 and the second lower pattern BP2 may extend along the second direction D2. The first sheet patterns SP1 may be disposed on the first lower pattern BP1 so as to be spaced apart from the first lower pattern BP1.

The number of first sheet patterns SP1 may be one or more. For example, the first sheet patterns SP1 may be a plurality of sheet patterns stacked in the first direction D1. The number of first sheet patterns SP1 is three in FIGS. 15-17, but the present disclosure is not limited thereto. An upper surface of the first sheet pattern SP1 disposed at the uppermost portion among the first sheet patterns SP1 may be an upper surface of the first active pattern AP1.

The first sheet pattern SP1 may be connected to the first source/drain pattern 150. The first sheet pattern SP1 may be a channel pattern used as a channel region of a transistor. For example, the first sheet pattern SP1 may be a nanosheet or a nanowire.

The first lower pattern BP1 may include, for example, silicon or germanium, which is an elemental semiconductor material. Alternatively, the first lower pattern BP1 may include a compound semiconductor, for example, a group IV-IV compound semiconductor or a group III-V compound semiconductor.

The first sheet pattern SP1 may include, for example, silicon or germanium, which is an elemental semiconductor material. Alternatively, the first sheet pattern SP1 may include a compound semiconductor, for example, a group IV-IV compound semiconductor or a group III-V compound semiconductor.

The first source/drain pattern 150 may be disposed on the first lower pattern BP1. The first source/drain patterns 150 may be disposed between the plurality of gate electrodes 120. The first source/drain pattern 150 may be connected to the first sheet pattern SP1.

The second source/drain pattern 250 may be disposed on the second lower pattern BP2. The second source/drain patterns 250 may be disposed between the plurality of gate electrodes 120. The second source/drain pattern 250 may be connected to the second sheet pattern.

The power rail via PVA may be disposed on one side of the first lower pattern BP1. The power rail via PVA is disposed on one side of the first source/drain pattern 150. In addition, the power rail via PVA may be disposed between the plurality of gate electrodes 120. The power rail via PVA may be disposed on one side of the second lower pattern BP2. The power rail via PVA is disposed on one side of the second source/drain pattern 250.

Although not illustrated, the gate insulating film 130 may extend along an upper surface of the first lower pattern BP1 and the upper surface of the field insulating film 105. The gate insulating film 130 may surround circumferences of the first sheet patterns SP1.

The gate electrode 120 is disposed on the first lower pattern BP1 and the second lower pattern BP2. The gate electrode 120 crosses the first lower pattern BP1 and the second lower pattern BP2. The gate electrode 120 may surround circumferences of the first sheet patterns SP1. The gate electrode 120 may surround circumferences of the second sheet patterns.

In FIG. 15, the gate spacer 140 includes an outer spacer 141 and inner spacers 142. The inner spacers 142 may be disposed between the first lower pattern BP1 and the first sheet pattern SP1 and between adjacent first sheet patterns SP1. Although not illustrated, the inner spacers 142 may be disposed between the second lower pattern BP2 and the second sheet pattern and between adjacent second sheet patterns.

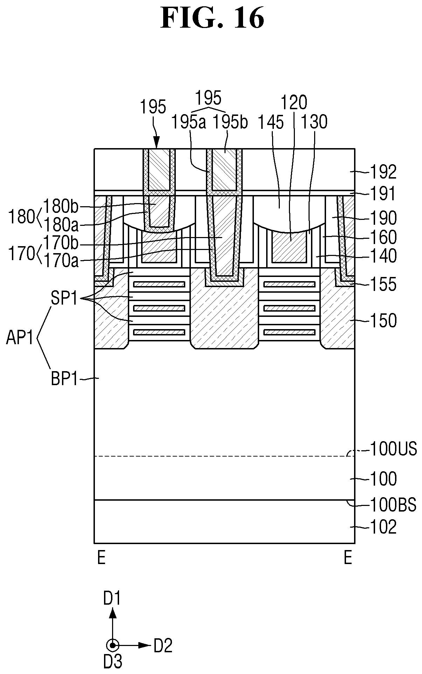

In FIG. 16, the gate spacer 140 includes only an outer spacer. The inner spacers are not disposed between the first lower pattern BP1 and the first sheet pattern SP1 and between adjacent first sheet patterns SP1. The inner spacers are not disposed between the second lower pattern BP2 and the second sheet pattern and between adjacent second sheet patterns.

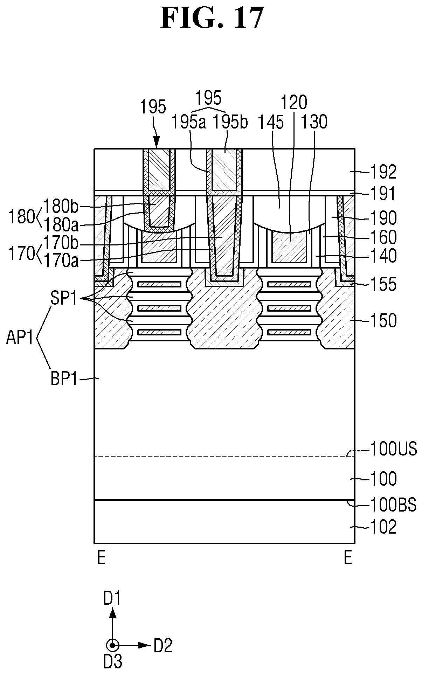

In FIG. 17, sidewalls of the first source/drain pattern 150 have a wavy shape. For example, the sidewalls of the first source/drain pattern 150 are concave toward the first sheet patterns SP1. The sidewalls of the first source/drain pattern 150 may be convex toward the gate electrode 120. However, the the present disclosure is not limited thereto. The sidewalls of the first source/drain patterns 150 may also be convex toward the first sheet patterns SP1.

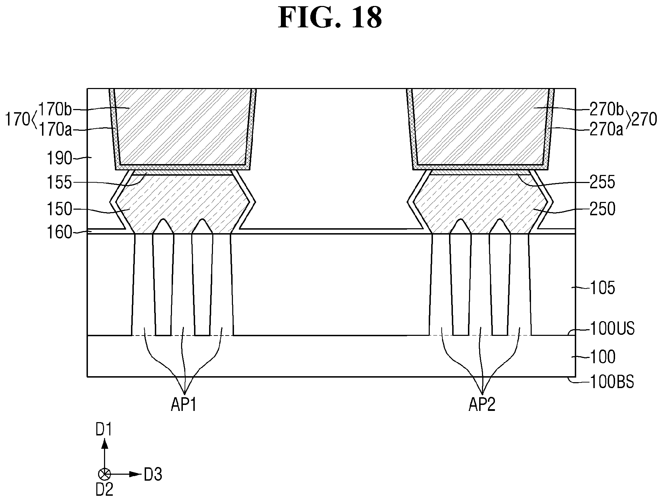

FIGS. 18 to 27 are views for describing intermediate steps of a method of manufacturing a semiconductor device. For reference, FIGS. 18 to 27 may be cross-sectional views taken along line A-A of FIG. 1. Hereinafter, a method of manufacturing a semiconductor device will be described with reference to cross-sectional views.

Referring to FIG. 18, the substrate 100 may be provided. The first active patterns AP1 and the second active patterns AP2 may be formed on the substrate 100. Each of the first active patterns AP1 and the second active patterns AP2 may extend in the second direction D2. The first active patterns AP1 and the second active patterns AP2 may be spaced apart from each other in the third direction D3. Each of the first active patterns AP1 and the second active patterns AP2 may protrude from the substrate 100 in the first direction D1.

The field insulating film 105 may be formed on the substrate 100. The field insulating film 105 may cover the sidewalls of the first active patterns AP1 and the sidewalls of the second active patterns AP2. The upper surface of the field insulating film 105 may be coplanar with the upper surface of the first active pattern AP1 and an upper surface of the second active pattern AP2.

Subsequently, the first source/drain pattern 150 may be formed on the first active patterns AP1. The second source/drain pattern 250 may be formed on the second active patterns AP2. The etch stop film 160 may be formed along the profile of the first source/drain pattern 150, the profile of the second source/drain pattern 250, and the upper surface of the field insulating film 105. The first interlayer insulating film 190 may be formed on the etch stop film 160.

Subsequently, the first source/drain contact 170 may be formed on the first source/drain pattern 150. The first source/drain contact 170 may penetrate through the first interlayer insulating film 190 and be connected to the first source/drain pattern 150. The first contact silicide film 155 may be formed at a boundary between the first source/drain contact 170 and the first source/drain pattern 150. The second source/drain contact 270 may be formed on the second source/drain pattern 250. The second source/drain contact 270 may penetrate through the first interlayer insulating film 190 and be connected to the second source/drain pattern 250. The second contact silicide film 255 may be formed at a boundary between the second source/drain contact 270 and the second source/drain pattern 250.

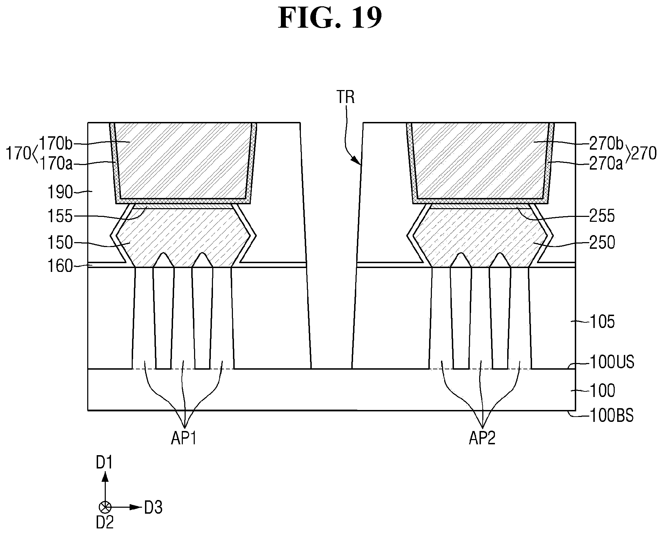

Referring to FIG. 19, a preliminary trench TR is formed. The preliminary trench TR may penetrate through the first interlayer insulating film 190, the etch stop film 160, and the field insulating film 105. The preliminary trench TR may expose the first surface 100US of the substrate 100.

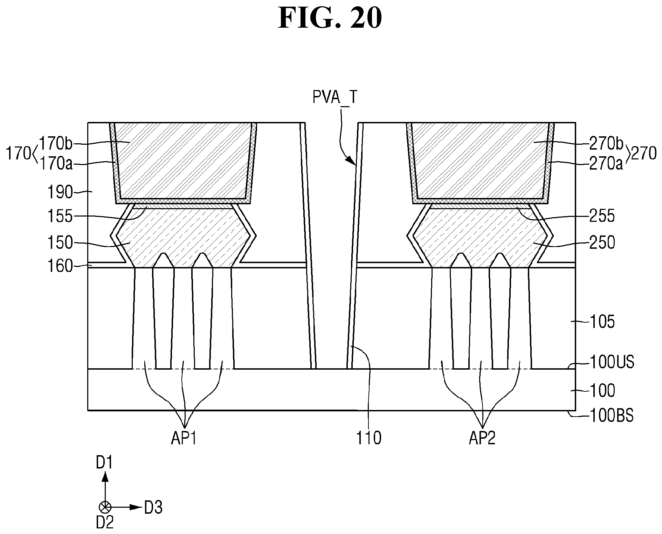

Referring to FIG. 20, the via insulating liners 110 is formed on sidewalls of the preliminary trench TR. The via insulating liners 110 may define the via trench PVA_T. The via insulating liners 110 are not formed on the first surface 100US of the substrate 100.

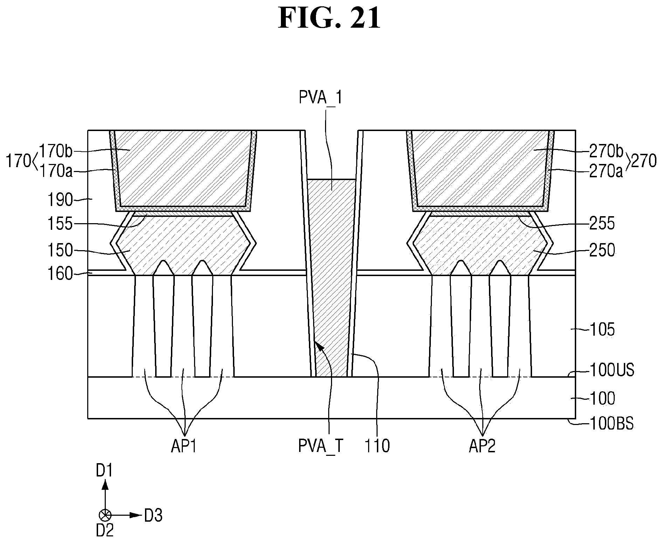

Referring to FIG. 21, the first sub-film PVA_1 may be formed within the via trench PVA_T.

The first sub-film PVA_1 may be formed in a bottom up manner. The "bottom up" manner may refer to a method in which a film to be deposited is deposited in a certain direction. For example, the first sub-film PVA_1 may be deposited in the first direction D1 on the first surface 100US of the substrate 100. In this case, the first sub-film PVA_1 may be formed as a single film.

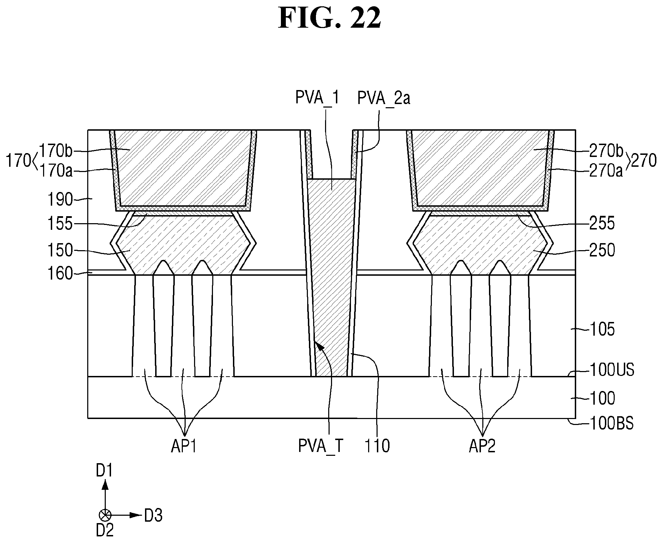

Referring to FIG. 22, the barrier films PVA_2a of the second sub-film PVA_2 are formed. The barrier films PVA_2a of the second sub-film PVA_2 may be formed on the via insulating liners 110. The barrier films PVA_2a of the second sub-film PVA_2 may be disposed on the inner sidewalls of the via trench PVA_T. The barrier films PVA_2a of the second sub-film PVA_2 are not formed along the upper surface of the first sub-film PVA_1.

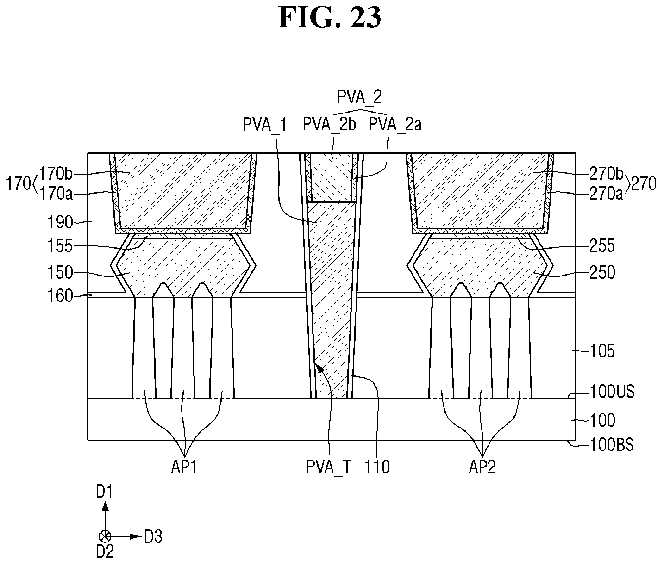

Referring to FIG. 23, the second sub-film PVA_2 are formed by forming the filling film PVA_2b of the second sub-film PVA_2. The power rail via PVA may be formed by forming the second sub-film PVA_2.

The filling film PVA_2b of the second sub-film PVA_2 may be formed between the barrier films PVA_2a of the second sub-film PVA_2. The filling film PVA_2b of the second sub-film PVA_2 may be formed on the upper surface of the first sub-film PVA_1. The filling film PVA_2b of the second sub-film PVA_2 may be in contact with the upper surface of the first sub-film PVA 1.

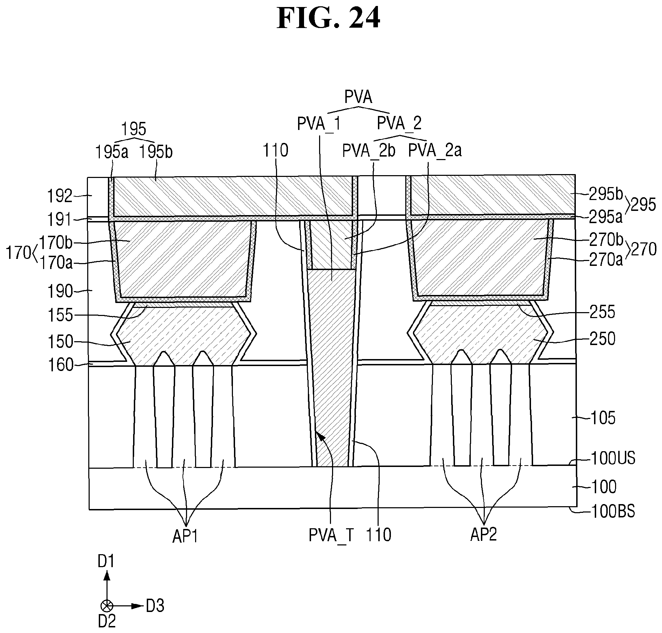

Referring to FIG. 24, the upper stop film 191, the second interlayer insulating film 192, the first via plug 195, and the second via plug 295 are formed on the first source/drain contact 170, the power rail via PVA, the second source/drain contact 270, and the first interlayer insulating film 190. The first via plug 195 may be connected to the first source/drain contact 170 and the power rail via PVA. The second via plug 295 may be connected to the second source/drain contact 270.

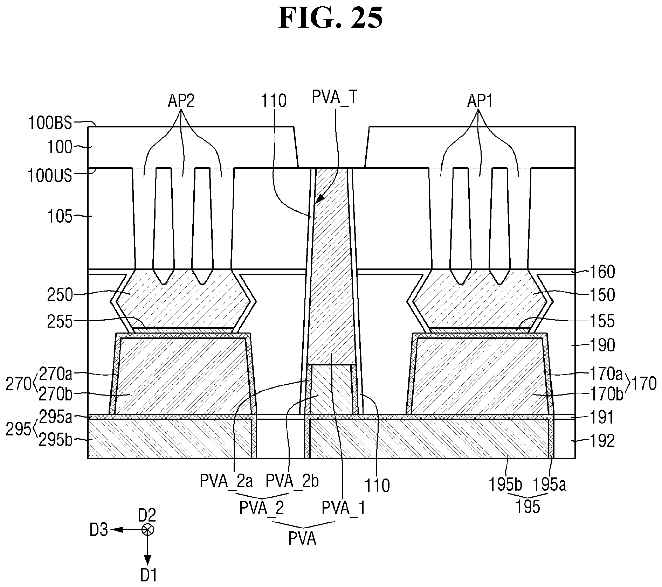

The reference frames in FIGS. 25-27 are rotated by 180° relative to the reference frame in FIG. 24. Although not illustrated, a capping substrate may be formed on the second interlayer insulating film 192, the second via plug 295, and the first via plug 195. The capping substrate may be a glass substrate or be a silicon substrate.

Subsequently, a buried trench exposing the power rail via PVA may be formed. The buried trench may be formed by etching the substrate 100. The buried trench may expose the power rail via PVA. A width of the buried trench may be greater than a width of the power rail via PVA, but is not limited thereto.

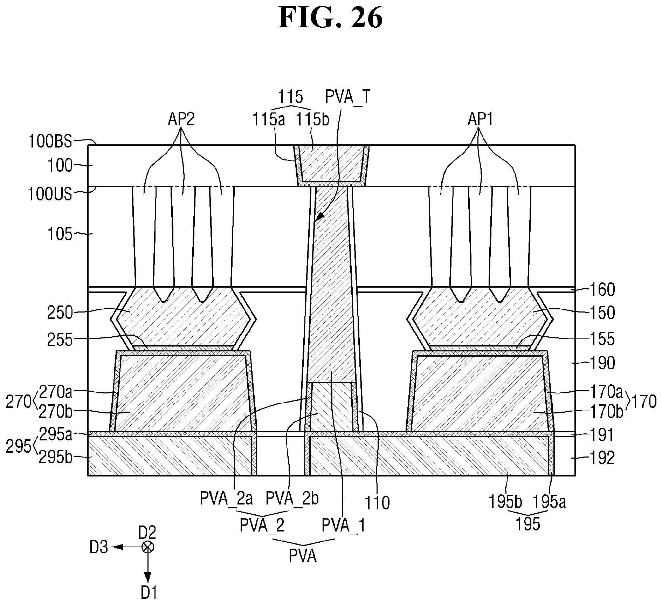

Referring to FIG. 26, the buried conductive pattern 115 is formed. First, the buried conductive pattern barrier film 115a may be formed along sidewalls and a bottom surface of the buried trench. The buried conductive pattern filling film 115b may be formed on the buried conductive pattern barrier film 115a.

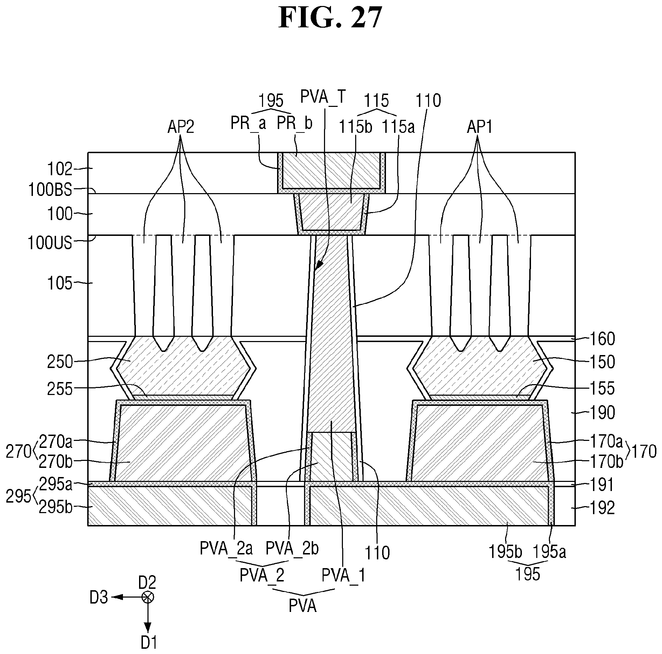

Referring to FIG. 27, the lower insulating film 102 may be formed on the second surface 100BS of the substrate 100. The power rail PR may be formed within the lower insulating film 102. The power rail PR may be connected to the buried conductive pattern 115.

While this disclosure contains many specific implementation details, these should not be construed as limitations on the scope of what is claimed.

Although the embodiments of the present disclosure have been described with reference to the accompanying drawings,
it should be understood that the embodiments as described above are not restrictive but illustrative in all respects.

## Claims

1. A semiconductor device comprising:
a substrate (100) including a first surface (100US) and a second surface (100BS) opposite to each other in a first direction (D1);
a first active pattern (AP1) disposed on the first surface (100US) of the substrate (100) and extending in a second direction (D2) intersecting the first direction (D1);
a field insulating film (105) disposed on the first surface (100US) of the substrate (100) and covering sidewalls of the first active pattern (AP1);
a power rail (PR) disposed on the second surface (100BS) of the substrate (100) and extending in the second direction (D2);
a via trench (PVA_T) disposed on one side of the first active pattern (AP1) and penetrating through the field insulating film (105);
a power rail via (PVA) filling the via trench (PVA_T) and connected to the power rail (PR); and
a via insulating liner (110) disposed between sidewalls of the via trench (PVA_T) and sidewalls of the power rail via (PVA),wherein the power rail via (PVA) includes:
a first sub-film (PVA_1) formed as a single film and filling
a lower portion of the via trench (PVA_T); and
a second sub-film (PVA_2) disposed at an upper portion of the via trench (PVA_T) on the first sub-film (PVA_1), wherein the second sub-film (PVA_2) includes a filling film (PVA_2b) and a barrier film (PVA_2a) disposed between sidewalls of the filling film (PVA_2b) and the via insulating liner (110), and
wherein
sidewalls of the first sub-film (PVA_1) are in contact with the via insulating liner (110).

2. The semiconductor device of claim 1, wherein the filling film (PVA_2b) of the second sub-film (PVA_2) is in contact with an upper surface of the first sub-film (PVA_1).

3. The semiconductor device of claim 1, wherein the barrier film (PVA_2a) includes a portion extending along an upper surface of the first sub-film (PVA_1).

4. The semiconductor device of claim 1, wherein the first sub-film (PVA_1) is composed of a different material from the filling film (PVA_2b).

5. The semiconductor device of claim 1, wherein the first sub-film (PVA_1) and the filling film (PVA_2b) are composed of the same material.

6. The semiconductor device of claim 1, wherein a height (H1) from the second surface (100BS) of the substrate (100) to an upper surface of the first sub-film (PVA_1) is greater than a height (H2) from the second surface (100BS) of the substrate (100) to an upper surface of the field insulating film (105).

7. The semiconductor device of claim 1, wherein at least a portion of the barrier film (PVA_2a) of the second sub-film (PVA_2) overlaps the first active pattern (AP1) along a third direction (D3) crossing the first and second directions (D1, D2).

8. The semiconductor device of claim 1, further comprising:
a buried conductive pattern (115) disposed in the substrate (100) and interposed between the power rail via (PVA) and the power rail (PR).

9. The semiconductor device of claim 1, further comprising:
a second active pattern (AP2) disposed on the first surface (100US) of the substrate (100), wherein the second active pattern (AP2) extends in the second direction (D2) and is spaced apart from the first active pattern (AP1) in a third direction (D3) crossing the first and second directions (D1, D2);
a plurality of gate electrodes (120) disposed on the first surface (100US) of the substrate (100), wherein the plurality of gate electrodes (120) cover the first and second active patterns (AP1, AP2), extend in the third direction (D3), and are spaced apart from each other in the second direction (D2); and
a first source/drain pattern (150) disposed between the plurality of gate electrodes (120) and a second source/drain pattern (250) disposed between the plurality of gate electrodes (120), wherein the first source/drain pattern (150) is connected to the first active pattern (AP1) and the second source/drain pattern (250) is connected to the second active pattern (AP2),
wherein the field insulating film (105) covers sidewalls of the second active pattern (AP2),
wherein the power rail via (PVA) is disposed between the plurality of gate electrodes (120) and between the first and second source/drain patterns (150, 250), and
wherein the barrier film (PVA_2a) does not extend along an upper surface of the first sub-film (PVA_1).

10. The semiconductor device of claim 9, further comprising:
a buried conductive pattern (115) disposed in the substrate (100) and interposed between the power rail via (PVA) and the power rail (PR).

11. The semiconductor device of claim 10, wherein a bottom surface of the first sub-film (PVA_1) is in contact with the buried conductive pattern (115).

12. The semiconductor device of claim 9, wherein the first sub-film (PVA_1) does not overlap the plurality of gate electrodes (120) in the second direction (D2).

13. The semiconductor device of claim 9, wherein the barrier film (PVA_2a) of the second sub-film (PVA_2) does not completely overlap the first source/drain pattern (150) and the second source/drain pattern (250) in the third direction (D3).

14. The semiconductor device of claim 9, further comprising:
a first source/drain contact (170) disposed on and connected to the first source/drain pattern (150); and
a second source/drain contact (270) disposed on and connected to the second source/drain contact (270), and
wherein the power rail via (PVA) is connected to at least some of the first and second source/drain contacts (170, 270).

15. The semiconductor device according to claim 1,
wherein the first active pattern (AP1) includes a lower pattern (BP1) extending in the second direction (D2) and one or more sheet patterns (SP1) spaced apart from the lower pattern (BP1) in the first direction (D1),
wherein the semiconductor device further comprises:
a gate electrode (120) disposed on the first surface (100US) of the substrate (100), surrounding the sheet patterns (SP1), and extending in a third direction (D3);
a source/drain pattern (150) disposed on one side of the gate electrode (120) and connected to the lower pattern (BP1);
a source/drain contact (170) disposed on the source/drain pattern (150) and connected to the source/drain pattern (150); and
a buried conductive pattern (115) disposed within the substrate (100) and connected to the power rail (PR), and
wherein the via trench (PVA_T) is disposed on one side of the gate electrode (120) and one side of the source/drain pattern (150) and penetrates through the field insulating film (105) to expose the buried conductive pattern (115),
wherein the power rail via (PVA) is connected to the buried conductive pattern (115) and connected to the source/drain contact (170), and
wherein the first sub-film (PVA_1) is connected to the buried conductive pattern (115).

## Patentansprüche

1. Halbleiterbauelement, umfassend:
ein Substrat (100), das eine erste Oberfläche (100US) und eine zweite Oberfläche (100BS) aufweist, die sich in einer ersten Richtung (D1) gegenüberliegen;
ein erstes aktives Muster (AP1), das auf der ersten Oberfläche (100US) des Substrats (100) angeordnet ist und sich in einer zweiten Richtung (D2) erstreckt, die die erste Richtung (D1) schneidet;
eine Feldisolationsschicht (105), die auf der ersten Oberfläche (100US) des Substrats (100) angeordnet ist und Seitenwände des ersten aktiven Musters (AP1) bedeckt;
eine Stromversorgungsleitung (PR), die auf der zweiten Oberfläche (100BS) des Substrats (100) angeordnet ist und sich in der zweiten Richtung (D2) erstreckt;
ein Via-Graben (PVA_T), der auf einer Seite des ersten aktiven Musters (AP1) angeordnet ist und die Feldisolationsschicht (105) durchdringt;
eine Stromversorgungsleitungs-Via (PVA), die den Via-Graben (PVA_T) ausfüllt und mit der Stromversorgungsleitung (PR) verbunden ist; und
eine Via-Isolierauskleidung (110), die zwischen Seitenwänden des Via-Grabens (PVA_T) und Seitenwänden der Stromversorgungsleitungs-Via (PVA) angeordnet ist,
wobei die Stromversorgungsleitungs-Via (PVA) aufweist:
eine erste Unterschicht (PVA_1), die als Einzelschicht ausgebildet ist und einen unteren Abschnitt des Via-Grabens (PVA_T) ausfüllt; und
eine zweite Unterschicht (PVA_2), die in einem oberen Abschnitt des Via-Grabens (PVA_T) auf der ersten Unterschicht (PVA_1) angeordnet ist, wobei die zweite Unterschicht (PVA_2) einen Füllfilm (PVA_2b) und einen Sperrfilm (PVA_2a) umfasst, der zwischen Seitenwänden des Füllfilms (PVA_2b) und der Via-Isolierauskleidung (110) angeordnet ist, und
wobei Seitenwände der ersten Unterschicht (PVA_1) in Kontakt mit der Via-Isolierauskleidung (110) stehen.

2. Halbleiterbauelement nach Anspruch 1, wobei der Füllfilm (PVA_2b) der zweiten Unterschicht (PVA_2) in Kontakt mit einer oberen Oberfläche der ersten Unterschicht (PVA_1) steht.

3. Halbleiterbauelement nach Anspruch 1, wobei der Sperrfilm (PVA_2a) einen Abschnitt aufweist, der sich entlang einer oberen Oberfläche der ersten Unterschicht (PVA_1) erstreckt.

4. Halbleiterbauelement nach Anspruch 1, wobei die erste Unterschicht (PVA_1) aus einem anderen Material besteht als der Füllfilm (PVA_2b).

5. Halbleiterbauelement nach Anspruch 1, wobei die erste Unterschicht (PVA_1) und der Füllfilm (PVA_2b) aus demselben Material bestehen.

6. Halbleiterbauelement nach Anspruch 1, wobei eine Höhe (H1) von der zweiten Oberfläche (100BS) des Substrats (100) bis zu einer oberen Oberfläche der ersten Unterschicht (PVA_1) größer ist als eine Höhe (H2) von der zweiten Oberfläche (100BS) des Substrats (100) bis zu einer oberen Oberfläche der Feldisolationsschicht (105).

7. Halbleiterbauelement nach Anspruch 1, wobei wenigstens ein Abschnitt des Sperrfilms (PVA_2a) der zweiten Unterschicht (PVA_2) das erste aktive Muster (AP1) entlang einer dritten Richtung (D3), die die erste und zweite Richtung (D1, D2) schneidet, überlappt.

8. Halbleiterbauelement nach Anspruch 1, weiterhin umfassend:
ein vergrabendes leitfähiges Muster (115), das im Substrat (100) angeordnet ist und zwischen der Stromversorgungsleitungs-Via (PVA) und der Stromversorgungsleitung (PR) angeordnet ist.

9. Halbleiterbauelement nach Anspruch 1, weiterhin umfassend:
ein zweites aktives Muster (AP2), das auf der ersten Oberfläche (100US) des Substrats (100) angeordnet ist, wobei das zweite aktive Muster (AP2) sich in der zweiten Richtung (D2) erstreckt und vom ersten aktiven Muster (AP1) in einer dritten Richtung (D3), die die erste und zweite Richtung (D1, D2) schneidet, beabstandet ist;
eine Vielzahl von Gate-Elektroden (120), die auf der ersten Oberfläche (100US) des Substrats (100) angeordnet sind, wobei die Vielzahl von Gate-Elektroden (120) die ersten und zweiten aktiven Muster (AP1, AP2) überdecken, sich in der dritten Richtung (D3) erstrecken und in der zweiten Richtung (D2) voneinander beabstandet sind; und
ein erstes Source/Drain-Muster (150), das zwischen der Vielzahl von Gate-Elektroden (120) angeordnet ist, und ein zweites Source/Drain-Muster (250), das zwischen der Vielzahl von Gate-Elektroden (120) angeordnet ist,
wobei das erste Source/Drain-Muster (150) mit dem ersten aktiven Muster (AP1) verbunden ist und das zweite Source/Drain-Muster (250) mit dem zweiten aktiven Muster (AP2) verbunden ist,
wobei die Feldisolationsschicht (105) Seitenwände des zweiten aktiven Musters (AP2) bedeckt,
wobei die Stromversorgungsleitungs-Via (PVA) zwischen der Vielzahl von Gate-Elektroden (120) und zwischen dem ersten und zweiten Source/Drain-Muster (150, 250) angeordnet ist, und
wobei der Sperrfilm (PVA_2a) sich nicht entlang einer oberen Oberfläche der ersten Unterschicht (PVA_1) erstreckt.

10. Halbleiterbauelement nach Anspruch 9, weiterhin umfassend:
ein vergrabendes leitfähiges Muster (115), das im Substrat (100) angeordnet ist und zwischen der Stromversorgungsleitungs-Via (PVA) und der Stromversorgungsleitung (PR) angeordnet ist.

11. Halbleiterbauelement nach Anspruch 10, wobei eine Bodenfläche der ersten Unterschicht (PVA_1) mit dem vergrabenen leitfähigen Muster (115) in Kontakt steht.

12. Halbleiterbauelement nach Anspruch 9, wobei die erste Unterschicht (PVA_1) die Vielzahl von Gate-Elektroden (120) in der zweiten Richtung (D2) nicht überlappt.

13. Halbleiterbauelement nach Anspruch 9, wobei der Sperrfilm (PVA_2a) der zweiten Unterschicht (PVA_2) das erste Source/Drain-Muster (150) und das zweite Source/Drain-Muster (250) in der dritten Richtung (D3) nicht vollständig überlappt.

14. Halbleiterbauelement nach Anspruch 9, weiterhin umfassend:
einen ersten Source/Drain-Kontakt (170), der auf dem ersten Source/Drain-Muster (150) angeordnet ist und mit diesem verbunden ist; und
einen zweiten Source/Drain-Kontakt (270), der auf dem zweiten Source/Drain-Muster (250) angeordnet ist und mit diesem verbunden ist, und
wobei die Stromversorgungsleitungs-Via (PVA) mit zumindest einigen der ersten und zweiten Source/Drain-Kontakte (170, 270) verbunden ist.

15. Halbleiterbauelement nach Anspruch 1,
wobei das erste aktive Muster (AP1) ein unteres Muster (BP1), das sich in der zweiten Richtung (D2) erstreckt, und ein oder mehrere Schichtmuster (SP1), die in der ersten Richtung (D1) vom unteren Muster (BP1) beabstandet sind, umfasst,
wobei das Halbleiterbauelement weiterhin umfasst:
eine Gate-Elektrode (120), die auf der ersten Oberfläche (100US) des Substrats (100) angeordnet ist, die Schichtmuster (SP1) umgibt und sich in einer dritten Richtung (D3) erstreckt;
ein Source/Drain-Muster (150), das auf einer Seite der Gate-Elektrode (120) angeordnet und mit dem unteren Muster (BP1) verbunden ist;
einen Source/Drain-Kontakt (170), der auf dem Source/Drain-Muster (150) angeordnet ist und mit dem Source/Drain-Muster (150) verbunden ist; und
ein vergrabenes leitfähiges Muster (115), das innerhalb des Substrats (100) angeordnet und mit der Stromversorgungsleitung (PR) verbunden ist,
wobei der Via-Graben (PVA_T) auf einer Seite der Gate-Elektrode (120) und einer Seite des Source/Drain-Musters (150) angeordnet ist und durch die Feldisolationsschicht (105) hindurch verläuft, um das vergrabene leitfähige Muster (115) freizulegen,
wobei die Stromversorgungsleitungs-Via (PVA) mit dem vergrabenen leitfähigen Muster (115) verbunden ist und mit dem Source/Drain-Kontakt (170) verbunden ist, und
wobei die erste Unterschicht (PVA_1) mit dem vergrabenen leitfähigen Muster (115) verbunden ist.

## Revendications

1. Dispositif semi-conducteur comprenant:
un substrat (100) comprenant une première surface (100US) et une deuxième surface (100BS) opposées l'une à l'autre selon une première direction (D1);
un premier motif actif (AP1) disposé sur la première surface (100US) du substrat (100) et s'étendant selon une deuxième direction (D2) croisant la première direction (D1);
un film isolant de champ (105) disposé sur la première surface (100US) du substrat (100) et recouvrant les parois latérales du premier motif actif (AP1);
une ligne d'alimentation (PR) disposée sur la deuxième surface (100BS) du substrat (100) et s'étendant selon la deuxième direction (D2);
une tranchée de via (PVA_T) disposée sur un côté du premier motif actif (AP1) et traversant le film isolant de champ (105);
une via d'alimentation (PVA) remplissant la tranchée de via (PVA_T) et connectée à la ligne d'alimentation (PR); et
un revêtement isolant de via (110) disposé entre les parois latérales de la tranchée de via (PVA_T) et les parois latérales de la via d'alimentation (PVA),
la via d'alimentation (PVA) comprenant:
une première sous-couche (PVA_1) formée en tant que film unique et remplissant une partie inférieure de la tranchée de via (PVA_T); et
une deuxième sous-couche (PVA_2) disposée dans une partie supérieure de la tranchée de via (PVA_T), sur la première sous-couche (PVA _1),
la deuxième sous-couche (PVA_2) comprenant un film de remplissage (PVA_2b) et un film barrière (PVA_2a) disposé entre les parois latérales du film de remplissage (PVA_2b) et le revêtement isolant de via (110), et
les parois latérales de la première sous-couche (PVA_1) étant en contact avec le revêtement isolant de via (110).

2. Dispositif semi-conducteur selon la revendication 1, dans lequel le film de remplissage (PVA_2b) de la deuxième sous-couche (PVA_2) est en contact avec une surface supérieure de la première sous-couche (PVA_1).

3. Dispositif semi-conducteur selon la revendication 1, dans lequel le film barrière (PVA_2a) comprend une portion s'étendant le long d'une surface supérieure de la première sous-couche (PVA_1).

4. Dispositif semi-conducteur selon la revendication 1, dans lequel la première sous-couche (PVA_1) est constituée d'un matériau différent de celui du film de remplissage (PVA_2b).

5. Dispositif semi-conducteur selon la revendication 1, dans lequel la première sous-couche (PVA_1) et le film de remplissage (PVA_2b) sont constitués du même matériau.

6. Dispositif semi-conducteur selon la revendication 1, dans lequel une hauteur (H1) entre la deuxième surface (100BS) du substrat (100) et une surface supérieure de la première sous-couche (PVA_1) est supérieure à une hauteur (H2) entre la deuxième surface (100BS) du substrat (100) et une surface supérieure du film isolant de champ (105).

7. Dispositif semi-conducteur selon la revendication 1, dans lequel au moins une partie du film barrière (PVA_2a) de la deuxième sous-couche (PVA_2) recouvre le premier motif actif (AP1) selon une troisième direction (D3) croisant les première et deuxième directions (D1, D2).

8. Dispositif semi-conducteur selon la revendication 1, comprenant en outre un motif conducteur enterré (115) disposé dans le substrat (100) et interposé entre la via d'alimentation (PVA) et la ligne d'alimentation (PR).

9. Dispositif semi-conducteur selon la revendication 1, comprenant en outre:
un deuxième motif actif (AP2) disposé sur la première surface (100US) du substrat (100), le deuxième motif actif (AP2) s'étendant selon la deuxième direction (D2) et étant espacé du premier motif actif (AP1) selon une troisième direction (D3) croisant les première et deuxième directions (D1, D2);
une pluralité d'électrodes de grille (120) disposées sur la première surface (100US) du substrat (100), la pluralité d'électrodes de grille (120) recouvrant les premier et deuxième motifs actifs (AP1, AP2), s'étendant selon la troisième direction (D3) et étant espacées les unes des autres selon la deuxième direction (D2); et
un premier motif source/drain (150) disposé entre la pluralité d'électrodes de grille (120) et un deuxième motif source/drain (250) disposé entre la pluralité d'électrodes de grille (120),
le premier motif source/drain (150) étant connecté au premier motif actif (AP1) et le deuxième motif source/drain (250) étant connecté au deuxième motif actif (AP2),
le film isolant de champ (105) recouvrant les parois latérales du deuxième motif actif (AP2),
la via d'alimentation (PVA) étant disposée entre la pluralité d'électrodes de grille (120) et entre les premier et deuxième motifs source/drain (150, 250), et
le film barrière (PVA_2a) ne s'étendant pas le long d'une surface supérieure de la première sous-couche (PVA_1).

10. Dispositif semi-conducteur selon la revendication 9, comprenant en outre un motif conducteur enterré (115) disposé dans le substrat (100) et interposé entre la via d'alimentation (PVA) et la ligne d'alimentation (PR).

11. Dispositif semi-conducteur selon la revendication 10, dans lequel une surface inférieure de la première sous-couche (PVA_1) est en contact avec le motif conducteur enterré (115).

12. Dispositif semi-conducteur selon la revendication 9, dans lequel la première sous-couche (PVA_1) ne recouvre pas la pluralité d'électrodes de grille (120) dans la deuxième direction (D2).

13. Dispositif semi-conducteur selon la revendication 9, dans lequel le film barrière (PVA_2a) de la deuxième sous-couche (PVA_2) ne recouvre pas complètement le premier motif source/drain (150) et le deuxième motif source/drain (250) dans la troisième direction (D3).

14. Dispositif semi-conducteur selon la revendication 9, comprenant en outre:
un premier contact source/drain (170) disposé sur le premier motif source/drain (150) et connecté à celui-ci; et
un deuxième contact source/drain (270) disposé sur le deuxième motif source/drain (250) et connecté à celui-ci, et
la via d'alimentation (PVA) étant connectée à au moins une partie des premier et deuxième contacts source/drain (170, 270).

15. Dispositif semi-conducteur selon la revendication 1,
dans lequel le premier motif actif (API) comprend un motif inférieur (BP1) s'étendant selon la deuxième direction (D2) et un ou plusieurs motifs en feuillet (SP1) espacés du motif inférieur (BP1) selon la première direction (D1),
le dispositif semi-conducteur comprenant en outre:
une électrode de grille (120) disposée sur la première surface (100US) du substrat (100), entourant les motifs en feuillet (SP1) et s'étendant selon une troisième direction (D3);
un motif source/drain (150) disposé sur un côté de l'électrode de grille (120) et connecté au motif inférieur (BP1);
un contact source/drain (170) disposé sur le motif source/drain (150) et connecté audit motif source/drain (150); et
un motif conducteur enterré (115) disposé dans le substrat (100) et connecté à la ligne d'alimentation (PR),
la tranchée de via (PVA_T) étant disposée sur un côté de l'électrode de grille (120) et sur un côté du motif source/drain (150) et traversant le film isolant de champ (105) pour exposer le motif conducteur enterré (115),
la via d'alimentation (PVA) étant connectée au motif conducteur enterré (115) et connectée au contact source/drain (170), et
la première sous-couche (PVA_1) étant connectée au motif conducteur enterré (115).
